# EUROPEAN PATENT APPLICATION

(11) **EP 4 354 505 A1**
(43) Date of publication of application: **17.04.2024**
(21) Application number: 22820427.7
(22) Date of filing: 13.05.2022
(51) Int. Cl.: H01L 27/30, H01L 51/42, H01L 51/44

(54) **SOLAR CELL, METHOD FOR MANUFACTURING SAME, AND SOLAR CELL MODULE COMPRISING SAME**

(30) Priority: 11.06.2021 KR 20210076182
(71) Applicant: Shangrao Xinyuan YueDong Technology Development Co. Ltd, Jiangxi Province 334100 (CN)
(72) Inventor: LEE, Giwon, Seoul 06772 (KR); LEE, Kyungdong, Seoul 06772 (KR); KIM, Hyunho, Seoul 06772 (KR); JUNG, Ilhyoung, Seoul 06772 (KR)
(74) Representative: Botti & Ferrari S.p.A.
(86) International application number: PCT/KR2022/006875
(87) International publication number: WO 2022/260299

(57) **Abstract**

A solar cell according to some embodiments of the present disclosure includes a first photoelectric conversion portion, a second photoelectric conversion portion, a side insulating layer, a first electrode, and a second electrode. The first photoelectric conversion portion includes a photoelectric conversion layer including a perovskite compound, a first transport layer on one side of the photoelectric conversion layer, and a second transport layer on the other side of the photoelectric conversion layer, the second photoelectric conversion portion is arranged below the second transport layer of the first photoelectric conversion portion and has a different material or structure from the first photoelectric conversion portion, the side insulating layer is formed on at least one side surface of the first photoelectric conversion portion, the first electrode is electrically connected to the first photoelectric conversion portion on one surface of the first photoelectric conversion portion serving as a light-receiving surface, and the second electrode is electrically connected to the second photoelectric conversion portion below the second photoelectric conversion portion. Therefore, a solar cell module that includes a photoelectric conversion portion including a perovskite compound, is further provided with a tandem structure provided with another photoelectric conversion portion having a different material or structure, and has excellent efficiency and reliability can be provided. In addition, a short-circuit current can be drastically reduced to 1/4 of an existing level while an active region of the solar cell with a tandem structure is ensured to a maximum extent.

## Description

### TECHNICAL FIELD

The present disclosure relates to a solar cell, a manufacturing method thereof, and a solar cell module, and in particular, to a solar cell module including a perovskite structure.

### BACKGROUND

A solar cell including a semiconductor substrate may have excellent photoelectric conversion efficiency and thus is widely used. However, the solar cell including the semiconductor substrate has certain limitations in improving the photoelectric conversion efficiency, so solar cells of various structures have been proposed.

As an example, a solar cell including a perovskite compound that absorbs short-wavelength light to perform photoelectric conversion using a short wavelength is proposed. However, when a photoelectric conversion layer is formed from this perovskite compound, a perovskite compound layer is formed by chemically combining an organic material and an inorganic material.

In order to form the perovskite compound layer as described above, in Korean Laid-Open Patent Publication No. 10-2018-0099577 (published on September 5, 2018), a method for coating a substrate with a perovskite solution to form the perovskite compound layer after the organic material and the inorganic material are mixed to prepare the solution is disclosed.

Then, a technology of forming a first photoelectric conversion region using a semiconductor substrate and then forming a perovskite compound layer thereon by deposition so as to manufacture a tandem cell is developed.

In the tandem cell as described above, although a second photoelectric conversion region is continuously formed by deposition on the first photoelectric conversion region below, the deposition is required to be performed in a state where the first photoelectric conversion region is fixed with a fixing portion of a deposition device. Therefore, an inactive region of the deposition device occurs in an edge region.

In order to reduce the inactive region as described above, various attempts have been made, but the problem of power reduction occurs due to the reduction of the inactive region of the cell.

In addition, when the edge region as described above is used as a space for forming a pad, since the pad with a terminal difference is formed along a side surface from an upper electrode, there is a risk that electrons separated from a perovskite layer are recombined with holes in the pad to cause short circuiting of a current.

### Related art reference

### Patent reference

Korean Laid-Open Patent Publication No. 10-2018-0099577 (published on September 5, 2018)

### SUMMARY

### Technical Problem

The present disclosure is intended to provide a solar cell and a solar cell module that include a photoelectric conversion portion including a perovskite compound, are further provided with a tandem structure provided with another photoelectric conversion portion having a different material or structure, and have excellent efficiency and reliability.

The present disclosure is intended to provide an optimal structure capable of ensuring an active region of a solar cell having a tandem structure.

The present disclosure is intended to provide an optimal structure capable of reducing current leakage of a solar cell having a tandem structure.

In addition, the present disclosure is intended to provide a manufacturing method capable of ensuring an active region of a solar cell having a tandem structure and reducing current leakage.

In addition, the present disclosure is intended to provide optimal arrangement between cells in a solar cell module including large-area perovskite compounds.

### Means of Solving the Technical Problem

A solar cell according to some embodiments of the present disclosure includes a first photoelectric conversion portion, a second photoelectric conversion portion, a side insulating layer, a first electrode, and a second electrode. The first photoelectric conversion portion includes a photoelectric conversion layer including a perovskite compound, a first transport layer on one side of the photoelectric conversion layer, and a second transport layer on the other side of the photoelectric conversion layer, the second photoelectric conversion portion is arranged below the second transport layer of the first photoelectric conversion portion and has a different material or structure from the first photoelectric conversion portion, the side insulating layer is formed on at least one side surface of the first photoelectric conversion portion, the first electrode is electrically connected to the first photoelectric conversion portion on one surface of the first photoelectric conversion portion serving as a light-receiving surface, and the second electrode is electrically connected to the second photoelectric conversion portion and arranged below the second photoelectric conversion portion.

The first photoelectric conversion portion may have a smaller area than the second photoelectric conversion portion to have a terminal difference region on the second photoelectric conversion portion, and the terminal difference region may be formed on two side surfaces of the first photoelectric conversion portion that are opposite to each other.

The side insulating layer may be formed in the terminal difference region formed on the two side surfaces of the first photoelectric conversion portion that are opposite to each other.

A cutting region in the light-receiving surface positioned across the first photoelectric conversion portion is not formed in the first electrode be.

The cutting region may have a shape extending in a first direction in a central region of the solar cell, and the side insulating layer may have a shape extending in the first direction in the terminal difference region.

The solar cell may include unit solar cell regions arranged between the cutting region and the side insulating layer, and the unit solar cell regions may be spaced apart from each other through the cutting region.

The first electrode may include first unit electrodes formed in each of the unit solar cell regions, and each of the first unit electrodes may include a pad portion formed on the side insulating layer, and busbar electrodes spaced apart from the pad portion and extending in a second direction perpendicular to the first direction.

The second electrode may include second unit electrodes formed in each of the unit solar cell regions, and each of the second unit electrodes corresponds to all of the busbar electrodes formed from the pad portion of the first unit electrode.

In addition, some embodiments of the present disclosure provide a solar cell. The solar cell includes a first photoelectric conversion portion, a second photoelectric conversion portion, a side insulating layer, a first electrode, and a second electrode. The first photoelectric conversion portion includes a first long side and a second long side formed along a major axis and parallel to each other and a first short side and a second short side formed along a minor axis intersecting the major axis and parallel to each other, and includes a photoelectric conversion layer including a perovskite compound, a first transport layer on one side of the photoelectric conversion layer, and a second transport layer on the other side of the photoelectric conversion layer, the second photoelectric conversion portion is arranged below the second transport layer of the first photoelectric conversion portion and has a different material or structure from the first photoelectric conversion portion, the side insulating layer is formed to abut against the first long side of the first photoelectric conversion portion, the first electrode is electrically connected to the first photoelectric conversion portion on one surface of the first photoelectric conversion portion serving as a light-receiving surface, and the second electrode is electrically connected to the second photoelectric conversion portion and arranged below the second photoelectric conversion portion. The first electrode includes a pad portion formed on the side insulating layer, and busbar electrodes extending from the pad portion, spaced apart from each other, and protruding along the minor axis.

In addition, some embodiments of the present disclosure provide a solar cell module. The solar cell module includes solar cells and connecting components connected between adjacent solar cells. Each of the solar cells includes a first photoelectric conversion portion, a second photoelectric conversion portion, a side insulating layer, a first electrode, and a second electrode. The first photoelectric conversion portion includes a first long side and a second long side formed along a major axis and parallel to each other and a first short side and a second short side formed along a minor axis intersecting the major axis and parallel to each other, and includes a photoelectric conversion layer including a perovskite compound, a first transport layer on one side of the photoelectric conversion layer, and a second transport layer on the other side of the photoelectric conversion layer, the second photoelectric conversion portion is arranged below the second transport layer of the first photoelectric conversion portion and has a different material or structure from the first photoelectric conversion portion, the side insulating layer is formed to abut against the first long side of the first photoelectric conversion portion, the first electrode is electrically connected to the first photoelectric conversion portion on one surface of the first photoelectric conversion portion serving as a light-receiving surface, and the second electrode is electrically connected to the second photoelectric conversion portion below the second photoelectric conversion portion. The first electrode includes a pad portion formed on the side insulating layer, and busbar electrodes extending from the pad portion, spaced apart from each other, and protruding along the minor axis.

A solar cell module in which the second electrode of one of the solar cells and the pad portion of the adjacent solar cell are electrically connected through overlapping between the adjacent solar cells is claimed.

The solar cells each may include a first overlapping portion overlapping with an adjacent upper solar cell and a second overlapping portion overlapping with an adjacent lower solar cell, and the connecting components each may include a conductive adhesive portion integrally arranged between the second overlapping portion of the upper solar cell and the first overlapping portion of the lower solar cell.

The pad portion and the conductive adhesive portion may contact with each other and be electrically connected.

The solar cells may be arranged apart from one another, and the connecting components each may connect the first electrode of one solar cell and the second electrode of another solar cell adjacent to the one solar cell.

The connecting component may contact with the pad portion of the first electrode of one of the solar cells, entirely cover the second electrode of the adjacent solar cell, and be electrically connected to the solar cells.

In addition, some embodiments of the present disclosure provide a solar cell manufacturing method. The solar cell manufacturing method includes: a step of forming a second photoelectric conversion portion including a conductive region on a semiconductor substrate; a step of forming side insulating layers on side surfaces opposite to each other on the second photoelectric conversion portion; a step of forming, inside the side insulating layers, a first photoelectric conversion portion including a photoelectric conversion layer including a perovskite compound, a first transport layer on one side of the photoelectric conversion layer, and a second transport layer on the other side of the photoelectric conversion layer; a step of forming, on one surface of the first photoelectric conversion portion serving as a light-receiving surface, a first electrode electrically connected to the first photoelectric conversion portion and having a cutting region to open a center and a second electrode electrically connected to the second photoelectric conversion portion below the second photoelectric conversion portion and having the cutting region; and a step of forming unit solar cells by cutting along the cutting region where the first electrode and the second electrode are not formed.

The step of forming side insulating layers may include: a step of arranging a mask exposing the side surface on the second photoelectric conversion portion; and a step of depositing a predetermined height of the side insulating layer on the exposed side surface.

In the step of forming a first electrode, the first electrode may be formed to include a pad portion formed on the side insulating layer, and busbar electrodes extending from the pad portion, spaced apart from each other, and protruding towards the cutting region.

The step of forming unit solar cells may include: a step of performing primary cutting on the solar cell to a predetermined depth from a back surface of the second photoelectric conversion portion by laser scribing; and a step of performing mechanical machining based on the cutting region to perform secondary cutting to separate the solar cell into the unit solar cells.

The predetermined depth in the primary cutting is a depth that may not reach the first photoelectric conversion portion.

### Technical Effect

According to this embodiment, a solar cell module that includes a photoelectric conversion portion including a perovskite compound, is further provided with a tandem structure provided with another photoelectric conversion portion having a different material or structure, and has excellent efficiency and reliability can be provided.

According to the present disclosure, a short-circuit current can be drastically reduced to 1/4 of an existing level while an active region of the solar cell with a tandem structure is ensured to a maximum extent.

In addition, since the present disclosure has a half-cut structure, the short-circuit current is reduced to 1/4, thereby reducing an output loss. Therefore, a cell to module (CMT) loss can be ameliorated and output can be increased.

In addition, optimal arrangement between pad structures and cells in a solar cell module including large-area perovskite compounds can be provided, so as to perform modularization.

### BRIEF DESCRIPTION OF DRAWINGS

FIG. 1 is a plan view of a solar cell according to some embodiments of the present disclosure;
FIG. 2 is a rear view of the solar cell according to some embodiments of the present disclosure;
FIG. 3 is a sectional view of the solar cell in FIG. 1 taken along I-I';
FIG. 4 is a sequence diagram for manufacturing the solar cell according to some embodiments of the present disclosure;
FIG. 5a to FIG. 10b are process diagrams for manufacturing the solar cell according to some embodiments of the present disclosure;
FIG. 11a is a plan view of a solar cell according to some other embodiments of the present disclosure, and FIG. 11b is a rear view of the solar cell according to some other embodiments of the present disclosure;
FIG. 12 is a sectional view of modular unit solar cells used in the present disclosure;
FIG. 13 is a plan view of a solar cell module according to some embodiments of the present disclosure;
FIG. 14 is a sectional view of the solar cell module in FIG. 13 taken along VII-VII';
FIG. 15 is a plan view of Part A in FIG. 14;
FIG. 16 is a sectional view of a solar cell module in the case of the unit solar cells as shown in FIG. 11a and FIG. 11b;
FIG. 17 is a plan view of a solar cell module according to some other embodiments of the present disclosure;
FIG. 18 is an exploded perspective view of the solar cell module shown in FIG. 17; and
FIG. 19 is a sectional view of the solar cell module shown in FIG. 17.

### Reference signs:

100, 100': solar cell module
10: solar cell
10': unit solar cell
20: connecting component
22: wiring
110: first photoelectric conversion portion
120: second photoelectric conversion portion
110a: junction layer
130: side insulating layer
42: first electrode
44: second electrode

### DESCRIPTION OF EMBODIMENTS

Embodiments of the present disclosure will be described in detail below with reference to the accompanying drawings. However, the present disclosure is not limited to such embodiments, and may be modified into various forms.

In order to clearly and briefly explain the present disclosure, illustration of parts irrelevant to the description in the accompanying drawings is omitted, and throughout the specification, same reference signs are used for same or very similar parts. In addition, in order to make the description clearer, the thickness, the width, and the like are enlarged or reduced and shown in the accompanying drawings, and the thickness, the width, and the like in the present disclosure are not limited to those shown in the accompanying drawings.

Moreover, throughout the specification, when a portion is referred to as "including" another portion, the another portion is not excluded and may be included unless otherwise specifically stated. In addition, when a portion of a layer, a film, a region, a panel, or the like is "on" another portion, this includes not only being "directly on" the another portion, but also having another portion positioned therebetween. When a portion of a layer, a film, a region, a panel, or the like is referred to as being "directly on" another portion, it means that no another portion is positioned therebetween.

A solar cell and a solar cell manufacturing method according to some embodiments of the present disclosure will be described in detail below with reference to the accompanying drawings.

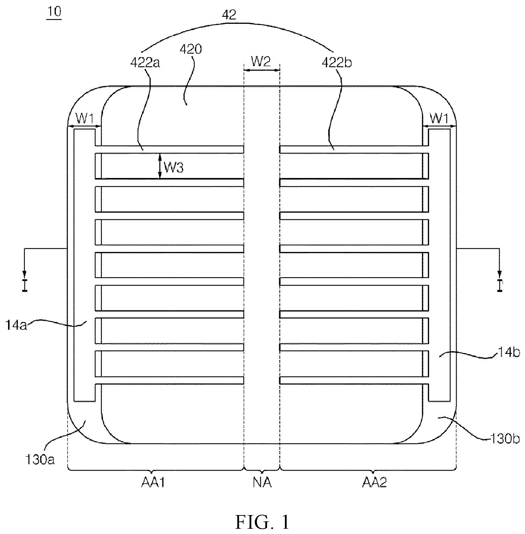

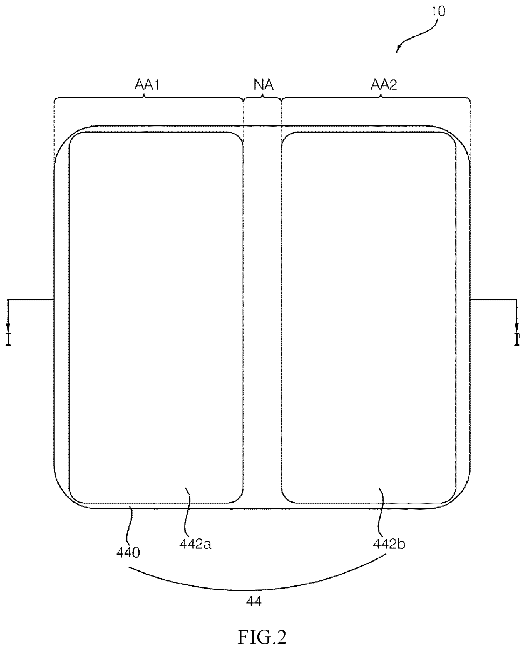

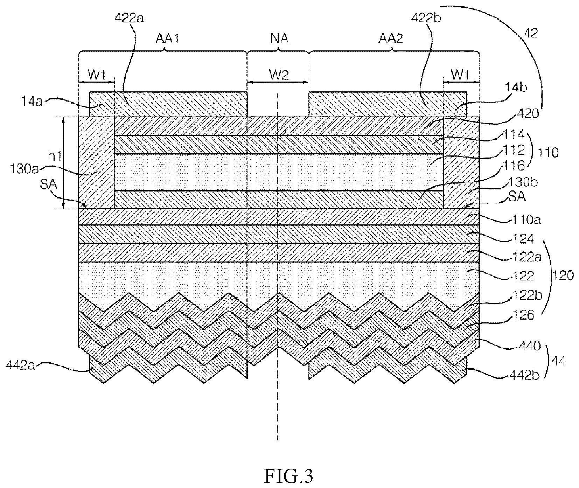

FIG. 1 is a plan view of a solar cell according to other embodiments of the present disclosure, FIG. 2 is a rear view of the solar cell according to some embodiments of the present disclosure, and FIG. 3 is a sectional view of the solar cell in FIG. 1 taken along I-I'.

A solar cell 10 according to some embodiments of the present disclosure serves as a tandem solar cell 10, which, in a vertical direction as a stacking direction, may include a first photoelectric conversion portion 110 including a photoelectric conversion layer 112 including a perovskite compound, and a first electrode 42 and a second electrode 44 that are electrically connected thereto. Herein, the photoelectric conversion layer 112 including the perovskite compound may be formed as a thick film having a thickness greater than a predetermined thickness, and may be formed to have a uniform composition in the stacking direction. In addition, the solar cell 10 according to this embodiment may have a tandem structure further including the second photoelectric conversion portion 120 having a different material or structure from the first photoelectric conversion portion 110. In addition, the solar cell 10 according to this embodiment, as a large-area solar cell, may form a large-area perovskite solar cell 10 with a diameter ranging from 10 cm to 20 cm, which ranges from 12 cm to 17 cm in some embodiments.

As shown in FIG. 1 and FIG. 2, the solar cell 10 according to this embodiment defines, on a plane, a plurality of solar cell regions AA1 and AA2 as regions provided with conductive regions and electrodes where photoelectric conversion substantially occurs, and a cutting region NA is positioned across the solar cell 10 between the solar cell regions AA1 and AA2 adjacent to each other. Such a solar cell 10 constitutes a plurality of solar cells AA1 and AA2 that are cut and separated along the cutting region NA. The separate solar cells AA1 and AA2 are provided with respective solar cell regions AA1 and AA2 so as to function as individual solar cells.

Hereinafter, for clearer distinction, the solar cell 10 split by cutting the cutting region NA of the solar cell 10 is referred to as unit solar cells AA1 and AA2. These are terms used only for the purpose of clarity, in addition to the solar cell 10, the unit solar cells AA1 and AA2 actually used as a solar cell (denoted by same reference signs as the solar cell regions) may also be considered as a solar cell, and the present disclosure is not limited to such terms.

Firstly, after sectional structures of the solar cell regions AA1 and AA2 are described with reference to FIG. 3, specific planar shapes in the solar cell 10 are described in detail with reference to FIG. 1 and FIG. 2 again.

Referring to FIG. 3, in the solar cell 10 according to this embodiment, the second photoelectric conversion portion 120 may have a pn junction structure including a semiconductor substrate 122. As an example, the second photoelectric conversion portion 120 may include a semiconductor substrate 122, and conductive regions 124 and 126 formed in the semiconductor substrate 122 or on the semiconductor substrate 122. The conductive regions 124 and 126 may include a first conductive region 124 having a first conductivity type and a second conductive region 126 having a second conductivity type.

The semiconductor substrate 122 may be composed of a crystalline semiconductor (e.g., a monocrystalline or polycrystalline semiconductor, monocrystalline or polycrystalline silicon as an example) including a single semiconductor material (a Group IV element as an example). Then, based on the semiconductor substrate 122 with high crystallinity and few defects, the second photoelectric conversion portion 120 may have excellent electrical properties. As an example, the second photoelectric conversion portion 120 may have a crystalline silicon solar cell structure.

In this embodiment, the semiconductor substrate 122 may include a base region having a first or second conductivity type by being doped with a first- or second-conductivity-type dopant having doping concentration lower than that of the first semiconductor layer 124 or the second semiconductor layer 126. That is, the semiconductor substrate 122 may include only the base region without a doping region formed by additionally doping the base region with a dopant.

A first passivation film 122a is formed on a front surface of the semiconductor substrate 122, and a second passivation film 122b is formed on a back surface of the semiconductor substrate 122.

The first conductive region 124 having the first conductivity type may be formed (contact as an example) on the first passivation film 122a. Moreover, the second conductive region 126 having the second conductivity type opposite to the first conductivity type may be positioned (contact as an example) on the second passivation film 122b.

The first conductive region 124 may be a region including a first-conductivity-type dopant and having the first conductivity type. Moreover, the second conductive region 126 may be a region including a second-conductivity-type dopant and having the second conductivity type.

In this embodiment, when the semiconductor substrate 122 (or the base region) has the first conductivity type, the second conductive region 126 may constitute an emission region forming a pn junction with the semiconductor substrate 122. The first conductive region 124 may constitute a front surface field region in which a front surface field is formed to prevent recombinations. Then, since the emission region directly involved in photoelectric conversion is located on the back surface, the emission region may be formed with a sufficient thickness (formed to be thicker than the front electric field region as an example) to further improve photoelectric conversion efficiency. However, the present disclosure is not limited thereto. Since the semiconductor substrate 122 has the second conductivity type, the first conductive region 124 may also constitute an emission region, and the second conductive region 126 may also constitute a back surface field region.

In this embodiment, the first conductive region 124 and the semiconductor substrate 122 may have an n type, and the second conductive region 126 may have a p type. Then, in the first photoelectric conversion portion 110 located on the second photoelectric conversion portion 120, a first transport layer 114 located above may transport electrons, and a second transport layer 116 located below may transport holes. Compared with an opposite case, in this case, the first photoelectric conversion portion 110 may bring an excellent effect. In addition, the semiconductor substrate 122 may have an n type, thereby prolonging a life time of the carriers. However, the present disclosure is not limited thereto, and the semiconductor substrate 122 has any one conductivity type of the first conductivity type and the second conductivity type, or has any one conductivity type of the n type and the p type, and may be modified in a variety of manners.

A junction layer (tunneling junction layer) 110a is located on a front surface of the second photoelectric conversion portion 120 to connect the second photoelectric conversion portion 120 with the first photoelectric conversion portion 110 located thereabove. Although it is shown in the drawing that the junction layer 110a is in direct contact with the first conductive region 124 and the first photoelectric conversion portion 110 respectively, the present disclosure is not limited thereto. The junction layer 110a may have a thin thickness, as an example, a thickness thinner than thicknesses of the electrode layers 420 and 440, so that so that tunneling of the carriers may occur smoothly.

The junction layer 110a may electrically connect the first photoelectric conversion portion 110 with the second photoelectric conversion portion 120, and may include a material through which light (long-wavelength light as an example) used in the first photoelectric conversion portion 110 can be transmitted. As an example, the junction layer 110a may include at least one of a transparent conductive material (transparent conductive oxide as an example), a conductive carbon material, a conductive polymer, and n-type or p-type amorphous silicon. In some other embodiments, the junction layer 110a may be formed as a structure in which silicon layers having different refractive indexes from each other are alternately stacked, so light (short-wavelength light as an example) used in the second photoelectric conversion portion 120 can be reflected by the second photoelectric conversion portion 120 and light (long-wavelength light as an example) used in the first photoelectric conversion portion 110 may be transmitted and provided to the first photoelectric conversion portion 110.

The junction layer 110a is formed to have an area the same as that of the second photoelectric conversion portion 120, and an area of the first photoelectric conversion portion 110 formed thereabove is formed to have an area smaller than that of the junction layer 110a.

Therefore, a terminal difference is formed around the first photoelectric conversion portion 110 due to an area difference between the second photoelectric conversion portion 120 and the first photoelectric conversion portion 110, so as to form a terminal difference region SA exposing the junction layer 110a below.

The terminal difference region SA as described above may be formed at two ends in a direction parallel to the cutting region NA centered on the cutting region NA in a central region.

For example, the terminal difference region SA may be formed on one side where pads of the unit solar cells AA1 and AA2 may be formed when the solar cell 10 is cut into two solar cell regions AA1 and AA2, and this may correspond to two side surfaces in the solar cell 10 prior to the cutting.

When the first photoelectric conversion portion 110 is formed on the second photoelectric conversion portion 120 by a deposition process, the two side surfaces of the solar cell 10 as described above are defined as a region where two legs of a fixing portion of a deposition machine that fixes the semiconductor substrate 122 of the solar cell 10 in the deposition machine are located on the semiconductor substrate 122.

Therefore, when the cutting region NA is formed in a length direction in the central region of the solar cell 10, the fixing portion of the deposition machine is located in the terminal difference region SA formed on the two side surfaces of the solar cell 10 in the length direction.

Therefore, the first photoelectric conversion portion 110 including the photoelectric conversion layer 112 including a perovskite compound may be positioned while the terminal difference region SA as described above is formed on the junction layer 110a. The first photoelectric conversion portion 110 is also only limitedly formed on the junction layer 110a to maintain the terminal difference region SA, so as to keep the area difference between the second photoelectric conversion portion 120 and the first photoelectric conversion portion 110 constant.

For example, the first photoelectric conversion portion 110 may include a photoelectric conversion layer 112, a second transport layer (second carrier transport layer) 116 on one side of the photoelectric conversion layer 112 and between the junction layer 110a and the photoelectric conversion layer 112, and a first transport layer (first carrier transport layer) 114 on the other side of the photoelectric conversion layer 112 and between the photoelectric conversion layer 112 and the first electrode 42.

The second transport layer 116 located on the junction layer 110a is a layer that extracts and transports a second carrier (a hole as an example) according to a bandgap relationship with the photoelectric conversion layer 112. As an example, the second carrier transported through the second transport layer 116 may pass through the junction layer 110a and move to the first photoelectric conversion portion 110.

The photoelectric conversion layer 112 located on the second transport layer 116 may be formed by a perovskite compound having a perovskite structure, and may be a photoactive layer that can be excited by light to form carriers (electrons and holes). As an example, the perovskite structure may have a chemical formula of AMX₃ (herein, A is a monovalent organic ammonium cation or metal cation; M is a divalent metal cation; X means a halogen anion). This photoelectric conversion layer 112 serves as AMX₃, which may include CH₃NH₃PbI₃, CH₃NH₃PbIₓCl₍₃₋ₓ₎, CH₃NH₃PbIₓBr₍₃₋ₓ₎, CH₃NH₃PbClₓBr₍₃₋ₓ₎, HC(NH₂)₂PbI₃, HC(NH₂)₂PbIₓCl₍₃₋ₓ₎, HC(NH₂)₂PbIₓBr₍₃₋ₓ₎, HC(NH₂)₂PbClₓBr₍₃₋ₓ₎, and the like, or may include a compound in which A of AMX₃ is partially doped with Cs. However, the present disclosure is not limited thereto, and a variety of materials may be used as the photoelectric conversion layer 112.

The photoelectric conversion layer 112 formed by a perovskite compound may have a thickness greater than the predetermined thickness, and may have a greater thickness than the first conductive region 124.

As an example, the predetermined thickness of the photoelectric conversion layer 112 may be formed to have a thickness of 400 nm to 800 nm or more, but is not limited thereto.

However, when the photoelectric conversion layer 112 is formed as a thick film having a thickness greater than a predetermined thickness d1, photoelectric efficiency can be improved, and the photoelectric conversion layer 112, when transferred in the stacking direction, may be formed to have a perovskite structure from a region meeting the second transport layer 116 to a region meeting the first transport layer 114 while the composition of the perovskite compound is maintained in the stacking direction.

Therefore, in a boundary region serving as the region meeting the first transport layer 114 or the region meeting the second transport layer 116, a basic material layer for forming the perovskite compound does not remain. Therefore, the problem of carrier blockage caused by the residue of the basic material layer is eliminated, so that a large-area thick film can be formed while the photoelectric efficiency is ensured.

The first transport layer 114 located on the photoelectric conversion layer 112 is a layer that extracts and transports a first carrier (an electron as an example) through a bandgap relationship with the photoelectric conversion layer 112.

The first electrode 42 may be located on the first photoelectric conversion portion 110 (the first transport layer 114 on the front surface thereof as an example), and the second electrode 44 may be located on the second photoelectric conversion portion 120 (the second conductive region 126 on the back surface thereof as an example). That is, the solar cell 10 according to this embodiment may have a tandem structure in which the second photoelectric conversion portion 120 based on a single semiconductor material (silicon as an example) is bonded to the first photoelectric conversion portion 110 based on a perovskite compound through the junction layer 110a.

In this embodiment, the first photoelectric conversion portion 110 has a larger bandgap than the second photoelectric conversion portion 120. That is, the first photoelectric conversion portion 110 has a relatively large bandgap to absorb a short wavelength that is relatively small and use the short wavelength to generate photoelectric conversion, and the second photoelectric conversion portion 120 has a bandgap lower than that of the first photoelectric conversion portion 110 to effectively absorb a long wavelength that is a wavelength larger than that of the light used in the first photoelectric conversion portion 110 and use the long wavelength to generate the photoelectric conversion.

In more detail, when light passes through the front surface of the solar cell 10 and is incident, the first photoelectric conversion portion 110 absorbs short wavelengths to generate electrons and holes through photoelectric conversion. In this case, the first carrier (an electron as an example) moves to the first electrode 42 side and is collected, and the second carrier (a hole as an example) passes through the first photoelectric conversion portion 110 and the second photoelectric conversion portion 120, moves to the second electrode 44 side, and is collected. When the long wavelength not used in but passing through the first photoelectric conversion portion 110 reaches the second photoelectric conversion portion 120, the second photoelectric conversion portion 120 absorbs the long wavelength and generates electrons and holes by the photoelectric conversion. In this case, the first carrier (an electron as an example) passes through the first photoelectric conversion portion 110, moves to the first electrode 42 side, and is collected, and the second carrier (a hole as an example) moves to the second electrode 44 side and is collected.

As described above, in this embodiment, since light having various wavelengths can be used in the plurality of photoelectric conversion portions 110 and 120, the efficiency of the solar cell 10 can be greatly improved. In particular, in this embodiment, a variety of properties may be improved by including the first photoelectric conversion portion 110 based on a perovskite compound and the second photoelectric conversion portion 120 having a hetero-junction structure. As an example, both the first photoelectric conversion portion 110 and the second photoelectric conversion portion 120 above may be formed in a low-temperature process, and it is easy to adjust a temperature range due to similar process temperatures, so process matching is achieved. In addition, since the first photoelectric conversion portion 110 and the second photoelectric conversion portion 120 above respectively have excellent open voltages, the efficiency of the solar cell 10 with a tandem structure can be greatly improved. A variety of structures are applicable to the second photoelectric conversion portion 120, and a variety of other modifications are possible.

In this embodiment, the first photoelectric conversion portion 110 may be formed by a low-temperature process (a low-temperature process below 200°C as an example), a temperature from room temperature to below 150°C as an example, and in an embodiment, room temperature (a temperature above 20°C and below 150°C as an example).

The first electrode 42 may include a first electrode layer 420 and second electrode layers 422a and 422b sequentially stacked on the photoelectric conversion portions 110 and 120. As an example, the first electrode layer 420 may be integrally formed (contact as an example) on the first photoelectric conversion portion 110 (for example, the first transport layer 114). "Integrally formed" may include not only a case where the entirety of the first photoelectric conversion portion 110 is covered without a blank space or blank region, but also a case where no part is formed inevitably. As described above, when the first electrode layer 420 is integrally formed on the first conductive region 124, the carriers can easily reach the second electrode layer 422 through the first electrode layer 420, thereby reducing resistance in a horizontal direction.

As described above, the first electrode layer 420 is integrally formed on the first photoelectric conversion portion 110, and thus may be composed of a material that can transmit light (a light-transmitting material). That is, the first electrode layer 420 is composed of a transparent conductive material to allow the carriers to move easily while enabling transmission of the light. Therefore, the first electrode layer 420 is integrally formed on the first photoelectric conversion portion 110 and does not block the transmission of the light. As an example, the first electrode layer 420 may include a transparent conductive material (for example, a transparent conductive oxide, an indium tin oxide (ITO) or the like as an example), a carbon nano tube (CNT), and the like. However, the present disclosure is not limited thereto, and the first electrode layer 420 may include a variety of other materials.

The second electrode layers 422a and 422b may be formed (contact as an example) on the first electrode layer 420. The second electrode layers 422a and 422b may be composed of a material having better electrical conductivity than the first electrode layer 420. Therefore, properties such as carrier collection efficiency and resistance reduction according to the second electrode layers 422a and 422b can be further improved. As an example, the second electrode layers 422a and 422b may be composed of an opaque metal having excellent electrical conductivity, or a metal having lower transparency than the first electrode layer 420.

As described above, the second electrode layers 422a and 422b are opaque or have low transparency and hinder incidence of light, and thus may have a predetermined pattern to minimize a shading loss. Therefore, light can be incident on a portion where the second electrode layers 422a and 422b are not formed.

In this embodiment, the second electrode layers 422a and 422b may be formed of an alloy having at least one of Ag, Cu, Al, Mo, Ti, Pd, W, and Pt, and may be formed by a deposition process.

The deposition process for forming the second electrode layers 422a and 422b may be vacuum deposition, sputtering, or electroplating. In this case, the second electrode layers 422a and 422b formed by deposition may be formed to have a thickness less than 5 µm.

The second electrode layers 422a and 422b may have a plurality of layered structures, but are not limited thereto.

In addition, the second electrode 44 may be located on the second photoelectric conversion portion 120, and as shown in FIG. 2, may have a double-layer structure of the first electrode layer 440 and the second electrode layer 442.

A function, a material, a shape, and the like of the first electrode layer 440 of the second electrode 44 are the same as or similar to those of the first electrode layer 420 of the first electrode 42, so the description thereof can be applied as it is.

In addition, as shown in FIG. 3, side insulating layers 130a and 130b are formed in the terminal difference region SA formed on the two sides of the first photoelectric conversion portion 110.

The side insulating layers 130a and 130b may be formed to have thicknesses equal to or greater than a height h1 from above the junction layer 110a to above the first photoelectric conversion portion 110 (i.e., a thickness of the first photoelectric conversion portion 110). In some embodiments, the thicknesses of the side insulating layers 130a and 130b may range from 10 nm to 1 µm.

The side insulating layers 130a and 130b are identically formed in the two terminal difference regions SA, so as to be formed, in the two side surfaces of one solar cell 10, in a shape of a bar type extending in the length direction, and the first photoelectric conversion portion 110 is arranged in a space formed between the two side insulating layers 130a and 130b on the two side surfaces.

Although the side insulating layers 130a and 130b may be formed by atomic deposition, chemical deposition, or physical deposition, the present disclosure is not limited thereto. Widths W1 of the side insulating layers 130a and 130b have a smaller-the-better characteristic, but according to necessity thereof, the widths W1 of the side insulating layers 130a and 130b on one side surface may satisfy a range from 0.1 mm to 3.0 mm, which may be adjusted according to a size of the fixing portion of the deposition machine.

The side insulating layers 130a and 130b may be formed of compounds including oxides, and as an example, SiC, SiN, or the like is applicable.

Referring to FIG. 1 and FIG. 2 again, on a plane, the solar cell 10 in this embodiment does not form the second electrode layers 422a, 422b, 442a, and 442b of the first electrode 42 and the second electrode 44 in the cutting region NA arranged in the central region. Respective layer structures of the first photoelectric conversion portion 110 and the second photoelectric conversion portion 120 may also be maintained in the cutting region NA.

As described above, since there are no second electrode layers 422a, 422b, 442a, and 442b in the cutting region NA, the first electrode layers 420 and 440 below may be exposed in the cutting region NA, and in a case where the second electrode layers 422a, 422b, 442a, and 442b are exposed and passivation (not shown) is additionally formed, the passivation may be exposed.

Except that the electrodes 42 and 44 are not formed, the cutting region NA has a same structure as the solar cell regions AA1 and AA2. Therefore, a detailed description thereof is omitted.

As shown in FIG. 1, the cutting region NA formed in the central region on the front surface of one solar cell 10 may be formed in a bar type extending in the length direction, and a second width W2 may be satisfied.

In this case, the terminal difference regions SA formed on the two side surfaces may also extend in the length direction parallel to the cutting region NA, each terminal difference region SA may have a first width W1, and the first width W1 may be less than the second width W2.

The solar cell 10 according to this embodiment may be cut along the cutting region NA to be split into a plurality of unit solar cells AA1 and AA2. As described above, when the solar cell 10 is split into two unit solar cells AA1 and AA2, a CTM loss occurring when a plurality of unit solar cells AA1 and AA2 are connected to manufacture a solar cell module may be reduced.

When a more detailed description thereof is provided, the CTM loss has a value of a square of a current multiplied by resistance in each solar cell 10, and has a value of the value of the square of the current multiplied by the resistance in each solar cell 10 multiplied by a number of solar cells 10 in the solar cell module including a plurality of solar cells. However, for the current generated by an area of the solar cell 10 in currents of the solar cells 10, when the area of the solar cell 10 becomes larger, the current also becomes larger. Moreover, when the area of the solar cell 10 becomes smaller, the current also becomes smaller.

For example, in this embodiment, when the solar cell 10 is cut to manufacture a plurality of unit solar cells AA1 and AA2 which are connected, the current decreases in proportion to the area, and the number of the unit solar cells AA1 and AA2 increases conversely. For example, in a case where one cutting region NA is provided and there are two solar cell areas AA1 and AA2, the current in each solar cell region AA1 or AA2 is reduced to 1/2 of the current of the solar cell 10, and the number of the unit solar cells AA1 and AA2 is twice that of the solar cell 10. As described above, since the current is reflected as a square value in the CTM loss and the number is reflected as it is, when the current is reduced to 1/2 and the number is doubled, the CTM loss is reduced to 1/2. Therefore, as in this embodiment, when the solar cell 10 is cut into a plurality of unit solar cells AA1 and AA2 to manufacture a solar cell module, the output loss of the solar cell module can be reduced.

In this embodiment, when a tandem solar cell 10 is manufactured and then cut to reduce an area of the unit solar cells AA1 and AA2, the tandem solar cell 10 is manufactured by using an existing device according to an optimized design as it is, followed by cutting. Therefore, a device burden and a process cost burden are minimized. Conversely, when the size of the solar cell 10 is reduced for manufacturing, there is a burden of replacing the device used or changing settings.

As described above, in this embodiment, the solar cell 100 is cut to manufacture a plurality of unit solar cells AA1 and AA2.

In this case, the second electrode layers 422a, 422b, 442a, and 442b are not formed in the cutting region NA to prevent efficiency reduction and defects that may occur in the cutting process, and block shunt passes according to the second electrode layers 422a, 422b, 442a, and 442b as highly conductive materials.

Therefore, problems that may occur in the cutting process can be minimized, and the unit solar cells AA1 and AA2 can have excellent efficiency, performance, and reliability.

In this embodiment, the cutting region NA may be formed in a direction (length direction) across the central region of the solar cell 10. That is, on the plane, the cutting region may be formed to connect two edges of the semiconductor substrate 122 that are opposite to each other.

Then, by cutting along the cutting region NA, a plurality of solar cell regions AA1 and AA2 can be separated independently of each other, and the cutting region NA may be stably formed while the area of the cutting region NA is minimized.

In this case, the cutting region (201) may have a shape extending along the length direction as a first direction (an up-down direction in the figure), and each of the solar cell regions AA1 and AA2 may extend along the first direction and be spaced apart from each other by the cutting region NA.

For simple description and illustration, in this embodiment, it is illustrated that two solar cell regions AA1 and AA2 are provided and one cutting region NA is positioned between the two solar cell regions AA1 and AA2. This is because the solar cell regions AA1 and AA2 have substantially a same area and thus have similar electrical properties.

However, the present disclosure is not limited thereto. Therefore, more than two cutting regions NA may be provided, and the number of solar cell regions AA1 and AA2 may be one more than the number of the cutting region NA.

The cutting region NA may have the second width W2 to such an extent that the electrodes 42 and 44 formed in a region other than the cutting region NA at the time of cutting are not affected in the cutting process. As an example, the second width W2 of the cutting region NA may range from 0.3 mm to 1 mm. When the second width W2 of the cutting region NA is less than 0.3 mm, problems may occur due to melting of the electrodes 42 and 44 in the solar cell regions AA1 and AA2 during cutting machining or due to flying materials. When the second width W2 of the cutting region NA exceeds 1 mm, an area of an emission region 20 is insufficient, so efficiency of the solar cell 100 or the unit solar cells 110a and 120a may be reduced. However, the present disclosure is not limited thereto, and the second width W2 of the cutting region NA may have various values.

The shapes of the first electrode 42 and the second electrode 44 according to the cutting region NA will be described in more detail.

In the following, a case where one cutting region NA is provided and the solar cell regions AA1 and AA2 are provided with a first solar cell region AA1 on one side of the cutting region NA and a second solar cell region AA2 on the other side of the cutting region NA is illustrated as an example.

Referring to FIG. 1, the first photoelectric conversion portion 110 and the first electrode 42 thereof are positioned on the front surface of the solar cell 10 according to this embodiment. In this case, the second electrode layers 422a and 422b of the first electrode 42 are not formed in the cutting region NA, and are positioned to correspond to the solar cell regions AA1 and AA2.

The first electrode 42 and the second electrode 44 are integrally formed in a region other than the cutting region NA, and a layer structure of the first photoelectric conversion portion 110 and the second photoelectric conversion portion 120 between the first electrode 42 and the second electrode 44 is integrally formed.

Then, maximization of the area of the first photoelectric conversion portion 110 and the second photoelectric conversion portion 120 constituting the emission region can help to improve photoelectric conversion efficiency of the solar cell 10 or the unit solar cells AA1 and AA2.

The second electrode layer 422a and 422b connected to the first electrode 42 of the first photoelectric conversion portion 110 may include a plurality of busbar electrodes 422a and 422b having a predetermined interval w3 and spaced apart from each other. Although a case where the busbar electrodes 422a and 422b are parallel to each other and parallel to one edge of the semiconductor substrate 122 is exemplified in the figure, the present disclosure is not limited thereto.

In this case, the busbar electrodes 422a formed in the first solar cell region AA1 and the busbar electrode 422b formed in the second solar cell region AA2 are spaced apart from each other in the cutting region NA.

The plurality of busbar electrodes 422a and 422b in the solar cell regions AA1 and AA2 may be formed in parallel to each other in the first direction, and have a structure in which one ends of the plurality of busbar electrodes 422a and 422b are connected to each other.

For example, as shown in FIG. 1, the plurality of busbar electrodes 422a formed in the first solar cell region AA1 may be connected to each other on a first side insulating layer 130a formed in the terminal difference region SA with one end being one end of the first solar cell region AA1.

As described above, a connection portion of the plurality of busbar electrodes 422a formed on the first side insulating layer 130a may serve as a pad portion 14a, and may have a shape of a bar type extending in the first direction in parallel with the cutting region NA.

One second electrode layer 422a formed in the first solar cell region AA1 includes a plurality of busbar electrodes 422a extending from the pad portion 14a formed on the first side insulating layer 130a and protruding in a second direction perpendicular to the first direction.

In this case, the pad portion 14a formed on the side insulating layer 130a may be formed as a unit pad cluster in which unit pads (not shown) connected at one ends of a predetermined number of the busbar electrodes 422a are spaced apart from each other, which is not limited.

Therefore, one second electrode layer 422a formed in the first solar cell region AA1 may include a plurality of busbar electrodes 422a extending from the pad portion 14a formed on the first side insulating layer 130a and protruding in a second direction perpendicular to the first direction, and the second electrode layer 422a may be formed into a shape of a comb in which the plurality of busbar electrodes 422a protrude from the pad portion 14a.

In this case, a width of the pad portion 14a may be greater than that of the busbar electrode 422a, and may be less than a spacing distance w3 between the busbar electrodes 422a adjacent to each other.

The pad portion 14a as described above may be used as a region for electrical and physical bonding with adjacent unit solar cells AA1 and AA2.

In addition, a second electrode layer 422b formed in the second solar cell region AA2 may be formed into a shape of a comb in which a plurality of busbar electrodes 422b protrude, in the second direction perpendicular to the first direction, from a pad portion 14b formed on a second side insulating layer 130b.

In fact, the shape of the second electrode layer 422a in the first solar cell region AA1 and the shape of the second electrode layer 422b in the second solar cell region AA2 may be formed symmetrically with respect to each other based on the cutting region NA, and sizes and shapes thereof may be symmetrical.

Herein, the second electrode layers 422a and 422b may also include boundary electrodes (not shown) formed continuously along edges of the solar cell region AA1 and AA2 to connect end portions of the plurality of busbar electrodes 422a and 422b within the solar cell regions AA1 and AA2.

As described above, when the boundary electrodes are included, carriers may be efficiently collected in portions located at the edges of the solar cell regions AA1 and AA2. However, the present disclosure is not limited thereto, and the boundary electrodes are not required.

Referring to FIG. 2, the second electrode 44 is located on the other surface (for example, a back surface) of the solar cell 10 according to this embodiment.

In this case, the second electrode 44 is not formed in the cutting region NA either, and is positioned to correspond to the solar cell regions AA1 and AA2.

In this embodiment, it is illustrated that a single cutting region NA is provided, and a first solar cell region AA1 and a second solar cell region AA2 are provided.

In this embodiment, the second electrode 44 connected to the second photoelectric conversion portion 110 on the back surface may be formed in a shape of a planar type covering the entire back surface.

That is, the second electrode layers 442a and 442b of the second electrode 44 may be integrally formed in a region other than the cut region NA, including a back-surface region corresponding to the terminal difference region SA.

Therefore, the second electrode layers 422a and 422b split into two may be formed on the back surface to cover from the pad portions 14a and 14b of the front surface to ends of the busbar electrodes 422a and 422b. As described above, like the second electrode layers 422a and 422b of the first electrode 42, the split two second electrode layers 422a and 422b may have shapes symmetrical to each other with respect to the cutting region NA. The materials of the second electrode layers 442a and 442b are described above, so descriptions thereof are omitted.

As illustrated in FIG. 1 and FIG. 2, for the solar cell regions AA1 and AA2, the second electrode layers 422a and 422b of the first electrode 42 formed on the front surface are formed to have a shape of a comb, and the second electrode layers 442a and 442b of the second electrode 44 formed on the back surface in the solar cell regions AA1 and AA2 are formed to have a shape of a planar type. However, the present disclosure is not limited thereto, planar shapes of the first electrode 42 and the second electrode 44 may be the same as each other, and various other modifications may also be available.

According to the solar cell 10 formed as described above, the solar cell regions AA1 and AA2 of two unit solar cells AA1 and AA2 formed across the cutting region NA of the central region are arranged in one solar cell 10, and thus outermost electrode layers 422a, 422b, 442a, and 442b of the first electrode 42 and the second electrode 44 are symmetrically formed.

The present disclosure is used for cutting the tandem solar cell shown in FIG. 1 to FIG. 3, and a manufacturing method thereof will be described in detail below.

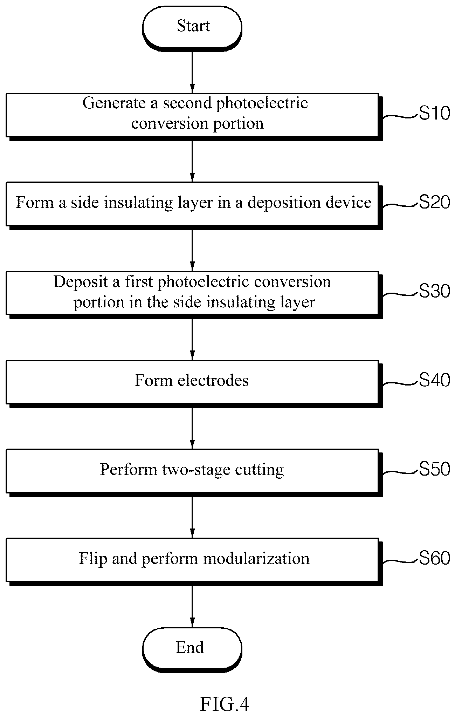

A manufacturing method for a unit solar cell according to some embodiments of the present disclosure will be described below with reference to FIG. 4 to FIG. 10b.

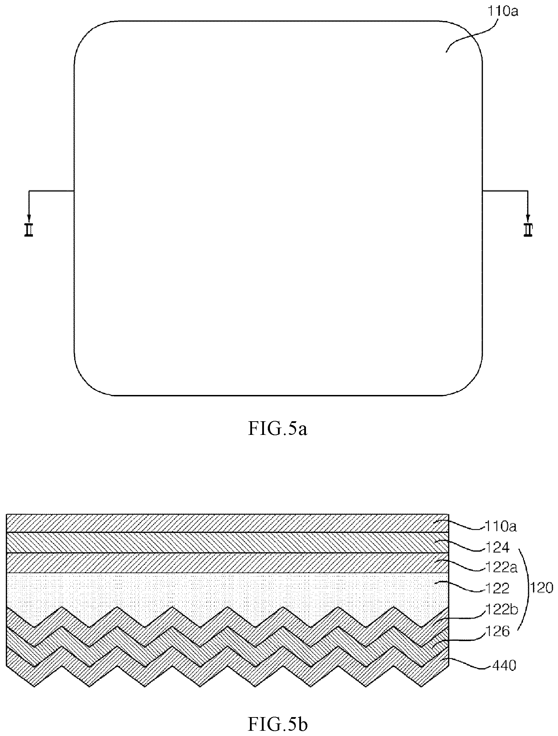

FIG. 4 is a sequence diagram for manufacturing the solar cell according to some embodiments of the present disclosure, and FIG. 5a to FIG. 10b are process diagrams for manufacturing the solar cell according to some embodiments of the present disclosure. In this case, in each figure, a is a plan view of the solar cell in most of the steps, and b is a sectional view of the solar cell in most of the steps.

As shown in FIG. 4, a solar cell manufacturing method according to some embodiments of the present disclosure includes a step of generating a second photoelectric conversion portion (S10), a step of forming a side insulating layer (S20), a step of generating a first photoelectric conversion portion (S30), a step of forming a first electrode and a second electrode (S40), a step of two-stage cutting (S50), and a step of modularization (S60). The method will be described in more detail.

As shown in FIG. 5a and FIG. 5b, in the step of forming a second photoelectric conversion portion 120 (S10), the second photoelectric conversion portion 120 including a semiconductor substrate 122, a first conductive region 124, a second conductive region 126, and the like is formed from the semiconductor substrate 122.

Firstly, the semiconductor substrate 122 formed into a base region having a first- or second- conductivity-type dopant is manufactured. In this case, at least one of a front surface and a back surface of the semiconductor substrate 122 may be textured to have unevenness to have an antireflection structure. Wet or dry texturing may be used for the texturing of the surface of the semiconductor substrate 122. The wet texturing may be performed by immersing the semiconductor substrate 122 in a texturing solution, and has an advantage of a short process time. In the dry texturing, the surface of the semiconductor substrate 122 is cut using a diamond grill, a laser, or the like, which may uniformly form the unevenness, but may have a long process time and cause damages to the semiconductor substrate 122. In addition, the semiconductor substrate 122 may be textured by reactive ion etching (RIE) or the like. As described above, in the present disclosure, the semiconductor substrate 122 may be textured with various methods.

Next, conductive regions 124 and 126 are formed on the surface of the semiconductor substrate 122. For example, a first passivation film and the first conductive region 124 are formed on the front surface of the semiconductor substrate 122, and a second passivation film and the second conductive region 126 are formed on the back surface of the semiconductor substrate 122.

The conductive regions 124 and 126 may be formed by thermal growth, deposition (e.g., chemical vapor deposition (CVD) or atomic layer deposition (ALD)), low-pressure chemical vapor deposition (LPCVD)), or the like. However, the present disclosure is not limited thereto.

The first- or second- conductivity-type dopant may also be included in a process of growing semiconductor layers forming the conductive regions 124 and 126, and may also be doped by ion implantation, thermal diffusion, laser doping, or the like after formation of the semiconductor layers. However, the present disclosure is not limited thereto, and the conductive regions 124 and 126 may be formed with various methods.

Next, as shown in FIG. 5b, a protective layer is formed on the second conductive region 126. In this case, in this embodiment, the first electrode layer 440 of the second electrode 44 may be formed into the protective layer on the second conductive region 126. The first electrode layer 440 functions as a protective layer in the second conductive region 126 to protect the second conductive region 126 in the manufacturing process, and may remain as it is to function as the first electrode layer 440. That is, in this embodiment, prior to the formation of the first photoelectric conversion portion 110, the first electrode layer 440 of the second electrode 44 is formed to be used as the protective layer, thereby simplifying the process. However, the present disclosure is not limited thereto, and a protective layer different from the first electrode layer 440 may be formed separately and the first electrode layer 440 may be formed in a state where the protective layer is removed or not removed.

As an example, the first electrode layer 440 of the second electrode 44 may be formed by sputtering. A sputtering process may be performed at a low temperature, and the first electrode layer 440 of the second electrode 44 may be formed only on a back surface as a single side. However, the present disclosure is not limited thereto, and various methods such as a coating method are applicable.

Next, a junction layer 110a is formed on the second photoelectric conversion portion 120. For example, the junction layer 110a may be formed on the entire first conductive region 124 of the second photoelectric conversion portion 120. As an example, the junction layer 110a may be formed by sputtering. A sputtering process may be performed at a low temperature, and as a single-sided process, the junction layer 110a may be formed only on the second conductive region 124. However, the present disclosure is not limited thereto, and various methods such as a coating method are applicable.

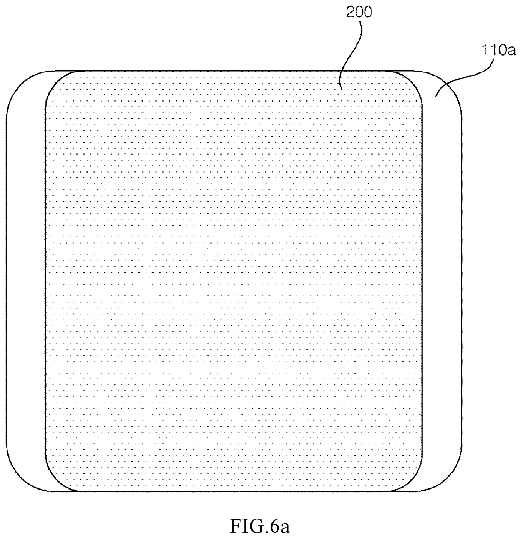

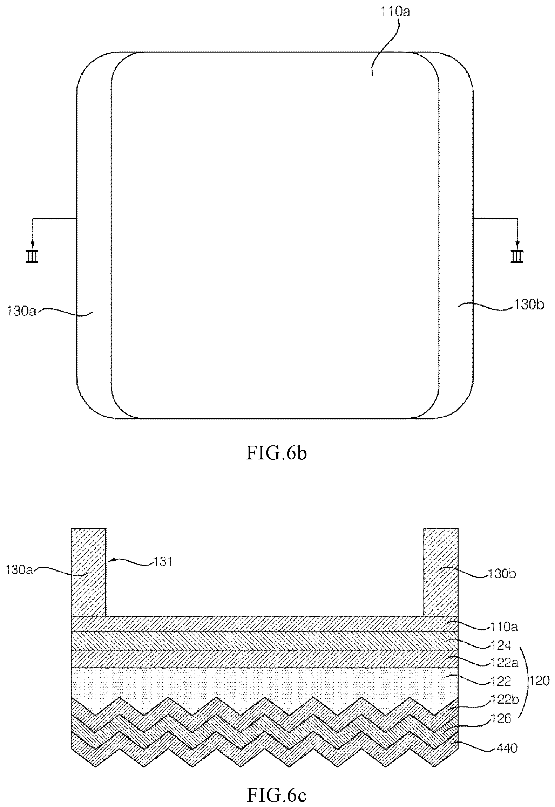

Next, as shown in FIG. 6a and FIG. 6b, side insulating layers 130a and 130b are formed on two side surfaces of the junction layer 110a (S20).

Firstly, as shown in FIG. 6a, after the solar cell 10 is mounted in a deposition device, a mask 200 exposing two side surfaces of the solar cell 10 and covering the central region is loaded on the front surface of the solar cell. The mask 200 may be a mask 200 formed of carbide, nitride, or the like, but is not limited thereto.

The side insulating layers 130a and 130b are deposited on the side surfaces exposed after being aligned to cover the central region of the solar cell 10.

In this case, as the deposition device, various methods such as atomic deposition, physical deposition, and chemical deposition are applicable, and thus, oxides such as SiO2 or carbides or nitrides of SiC or SiN are applicable on the side surface.

In this case, the side insulating layers 130a and 130b formed may have thicknesses H1 satisfying a range from 10 nm to 1 µm, and may be formed to be as high as or higher than the first photoelectric conversion portion 110 formed later. In addition, widths W1 of the side insulating layers 130a and 130b may satisfy a range from 0.1 mm to 0.3 mm, and may correspond to a contact area of a fixing portion of the deposition device for fixing the solar cell 10.

Therefore, the widths W1 of the side insulating layers 130a and 130b may comply with a smaller-the-better condition, but may be adjusted to substantially not exceed 0.3 mm.

As described above, an area occupied by the side insulating layers 130a and 130b is minimized, so that an area of photoelectric conversion can be ensured to a maximum extent, and a junction portion between the fixing portion of the deposition device and the solar cell 10 is ensured as an insulating layer, so as to prevent damages to the active region due to physical contact at the time of fixing.

As described above, when the side insulating layers 130a and 130b are formed on the two side surfaces of the junction layer 110a of the solar cell 10 respectively, as shown in FIG. 6b, the mask 200 is removed, and as shown in FIG. 6c, a groove 131 as a space is exposed between the side insulating layers 130a and 130b on the two side surfaces.

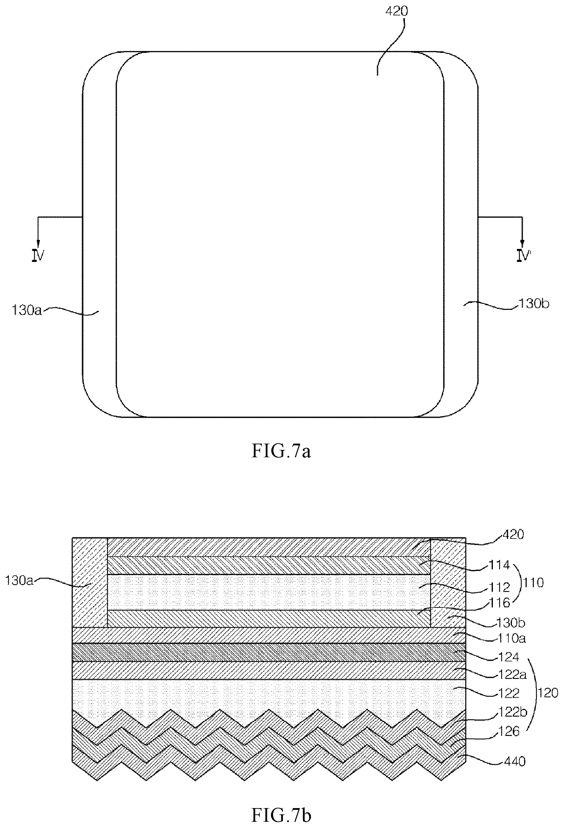

Next, as shown in FIG. 7a and FIG. 7b, a first photoelectric conversion portion 110 is formed (S30).

In the step of forming the first photoelectric conversion portion 110, the first photoelectric conversion portion 110 is formed on the junction layer 110a. In this case, the first photoelectric conversion portion 110 is selectively formed only in the groove 131 between the side insulating layers 130a and 130b.

For example, in the deposition device, a second transport layer 116, a photoelectric conversion layer 112, and a first transport layer 114 may be sequentially formed on the junction layer 110a in the groove 131 when legs of the fixing portion of the deposition device are fixed to upper parts of the side insulating layers 130a and 130b.

The second transport layer 116, the photoelectric conversion layer 112, and the first transport layer 114 may be formed by deposition (such as physical deposition or chemical deposition).

Next, a first electrode layer 420 of a first electrode 42 may be formed on the first photoelectric conversion portion 110. For example, the first electrode layer 420 of the first electrode 42 may be formed on the first transport layer 114.

As an example, the first electrode layer 420 of the first electrode 42 may be formed by sputtering. A sputtering process may be performed at a low temperature, and the first electrode layer 420 of the first electrode 42 may be formed only on a front surface as a single side. However, the present disclosure is not limited thereto, and various methods such as a coating method are applicable.

In addition, in this embodiment, it is illustrated that a first electrode layer 440 of a second electrode 44 is formed prior to the formation of the first photoelectric conversion portion 110, and the first electrode layer 420 of the first electrode 42 is formed after the formation of the first photoelectric conversion portion 110. However, the present disclosure is not limited thereto, and the first electrode layer 440 of the second electrode 44 may alternatively be formed after the formation of the first photoelectric conversion portion 110. In this case, the first electrode layer 440 of the second electrode 44 may alternatively be formed simultaneously with the first electrode layer 420 of the first electrode 42, and may be formed prior to or after the formation of the first electrode layer 420 of the first electrode 42. A variety of other modifications are possible.

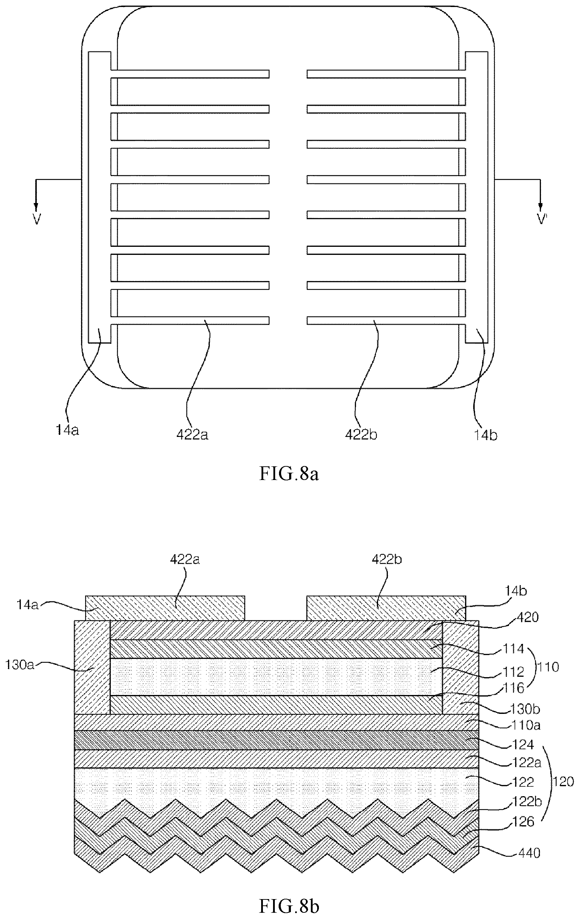

Next, as shown in FIG. 8a and FIG. 8b, in the step of forming the second electrode layer 422, a second electrode layer 422 of the first electrode 42 and a second electrode layer 442 of the second electrode 44 are formed (S40). In the following, although it is shown that the second electrode layers 422a and 422b of the first electrode 42 are formed as a single layer, a multi-layer structure may be formed in some other embodiments.

In this case, the second electrode layers 422a, 422b, 442a, and 442b of the first electrode 42 and the second electrode 44 are formed simultaneously.

Firstly, as shown in FIG. 8a, in order to form the second electrode layers 422a, 422b, 442a, and 442b of the first electrode 42 and the second electrode 44, a deposition process is performed.

In this case, as the deposition process, sputtering, vacuum deposition, or coating (electroplating) is applicable in various manners.

As an example, when a sputtering layer formed by sputtering is formed, a temperature in a process of forming the second electrode layers 422a, 422b, 442a, and 442b may be lower than 150°C (100°C to 145°C as an example). The second electrode layers 422a, 422b, 442a, and 442b may be formed by sputtering in a state where a mask or mask layer is provided, so that the second electrode layers 422a, 422b, 442a, and 442b have desired patterns. In addition, the second electrode layers 422a, 422b, 442a, and 442b may also include an additional conductive layer formed by sputtering or electroplating (electrolytic plating as an example) on the sputtering layer formed by sputtering. In addition, the second electrode layers 422a, 422b, 442a, and 442b of the first electrode 42 and the second electrode 44 according to this embodiment may be formed by various processes performed below 150°C.

In this case, as shown in FIG. 8b, the second electrode layers 422a and 422b of the first electrode 42 formed have two comb shapes formed symmetrically with respect to the cutting region NA, and the second electrode layers 422a and 422b of the second electrode 44 have two plane shapes that open the cutting region NA and are spaced apart from each other.

Therefore, on the front surface of the solar cell 10, pad portions 14a and 14b are formed on the side insulating layers 130a and 130b, and a plurality of busbar electrodes 422a, 422b protruding from the pad portions 14a and 14b towards he cutting region NA are formed. Moreover, on a lower surface of the solar cell 10, the second electrode layers 442a and 442b of the second electrode 44 in a plane shape are formed to correspond to an entire area from the pad portions 14a and 14b to the busbar electrodes 422a and 422b formed therein.

In this embodiment, after the second electrode layers 422a, 422b, 442a, and 442b are formed, by a deposition process, in the solar cell 100 provided with the first photoelectric conversion portion 110 including a perovskite compound, a covering layer may also be formed thereon to ensure a filling rate and excellent efficiency and reliability, so that the first electrode 42 and the second electrode 44 can be formed at a low temperature (i.e., below 150°C).

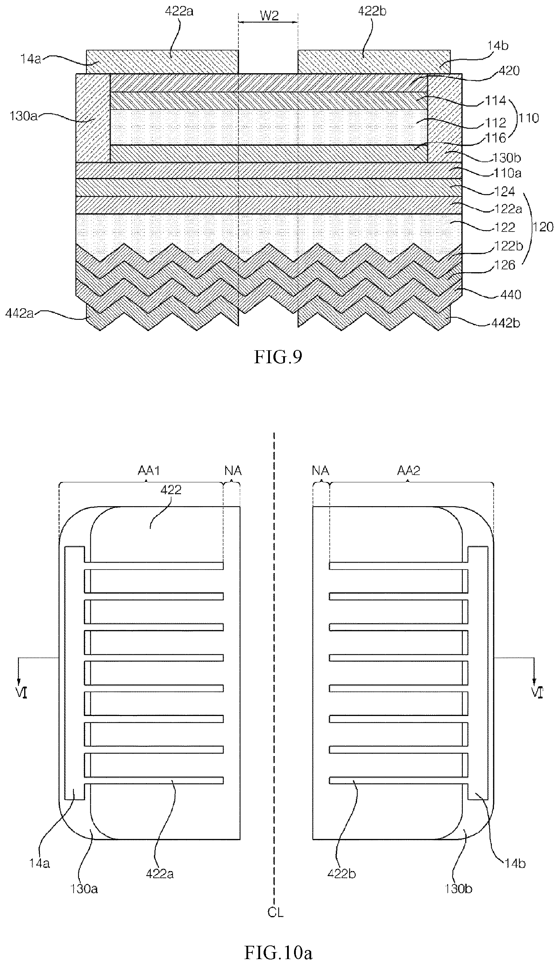

As described above, when the first electrode 42 and the second electrode 44 are formed, a solar cell shown in FIG. 9 is formed. The solar cell 10 in FIG. 9 is formed to have a shape of the front surface and the back surface as shown in FIG. 1 and FIG. 2.

Next, the solar cell 10 according to this embodiment may be cut along the cutting region NA into a plurality of unit solar cells AA1 and AA2.

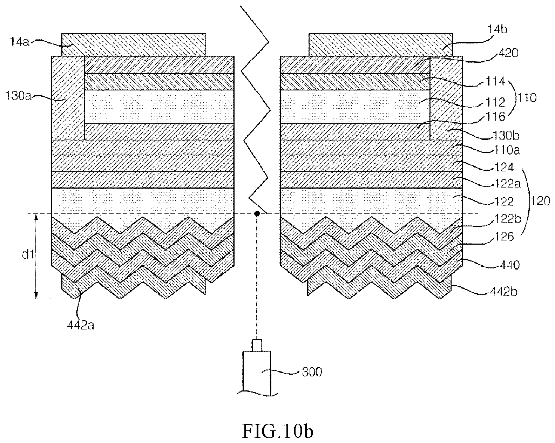

As shown in FIG. 10a, the solar cell 10 is cut along a cutting line CL in the cutting region NA of the solar cell 10 having the above structure, a plurality of unit solar cells AA1 and AA2 respectively corresponding to a plurality of solar cell regions AA1 and AA2 may be formed as shown in FIG. 10b.

As an example, as a method of cutting the cutting region NA, two-stage cutting methods such as laser machining and mechanical machining are applicable.

Preliminarily, in the laser machining, the solar cell 10 is cut to a predetermined depth by irradiating laser light to the cutting region NA to melt the part.

Cutting is performed in the back surface of the solar cell 10 according to the cutting depth d1 in the laser machining as described above, and is performed in the back surface of the solar cell 10 to the central region of the semiconductor substrate 122 of the second photoelectric conversion portion 120.

Therefore, since laser irradiation according to the laser machining is not performed on the first photoelectric conversion portion 110, damages to the perovskite compound by laser light may be prevented.

Secondarily, after the laser machining, a physical impact is applied to the substrate cut to the central region of the semiconductor substrate 122 by mechanical machining to cut the entirety.

In this case, there is also a clean machining surface in a narrow cutting region NA, and secondary machining of laser scribing and mechanical machining may be performed without damaging a perovskite layer.

Therefore, in the formed unit solar cells AA1 and AA2, the semiconductor substrate 122 has a major axis and a minor axis. Generally, the solar cell 10 is manufactured from an ingot of a substantially circular shape of the semiconductor substrate 122, and in a circle, a square, or a shape similar thereto, lengths of sides in two axes orthogonal to each other are the same or almost similar to each other. As an example, in this embodiment, the semiconductor substrate 122 of the solar cell 10 may have an octagonal shape having inclined sides at four corners from a square shape, or a plate shape having a rounded fillet surface. In this shape, the semiconductor substrate 122 with the widest area can be obtained from the ingot. Therefore, the solar cell 10 has horizontal and vertical axes at a same distance.

In this embodiment, since the solar cell 10 is cut along the cutting region NA to form the unit solar cells AA1 and AA2, the semiconductor substrate 122 of the unit solar cells AA1 and AA2 has a shape including a major axis and a minor axis.

For example, as shown in FIG. 10a, the unit solar cells AA1 and AA2 include a first long side and a second long side formed along a major axis (a longitudinal direction in the figure) and parallel to each other and a first short side and a second short side formed along a minor axis (a transverse direction in the figure) intersecting the major axis and parallel to each other. Herein, one of the long sides is an edge formed by cutting through the cutting line CL.

The other of the long sides serves as an edge at which side insulating layers 130a and130b are formed, and pad portions 14a and 14b are formed therein.

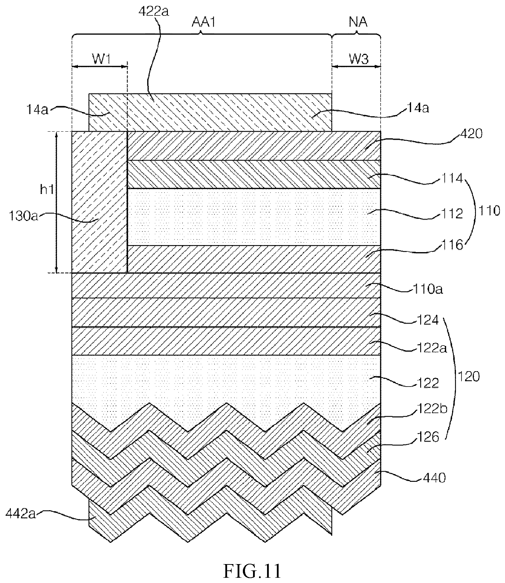

Since the cutting region NA is cut to form the unit solar cells AA1 and AA2, an edge with a width W3 which is about half of the width W2 of the cutting region NA is formed in an edge of the unit solar cells AA1 and AA2, as shown in FIG. 11. Such edge portions are positioned along a long side. Therefore, the electrodes 42 and 44 are formed in edge portions formed by cutting the cutting region NA.

As described above, in the unit solar cells AA1 and AA2, two long sides may be formed to be asymmetrical to each other, and two short sides may be formed to be symmetrical to each other. Moreover, two unit solar cells AA1 and AA2 formed by cutting have a same shape as each other.

As described above, a plurality of unit solar cells AA1 and AA2 formed by cutting one solar cell 10 have a cross section as shown in FIG. 11, and may be modularized into various forms on glass.

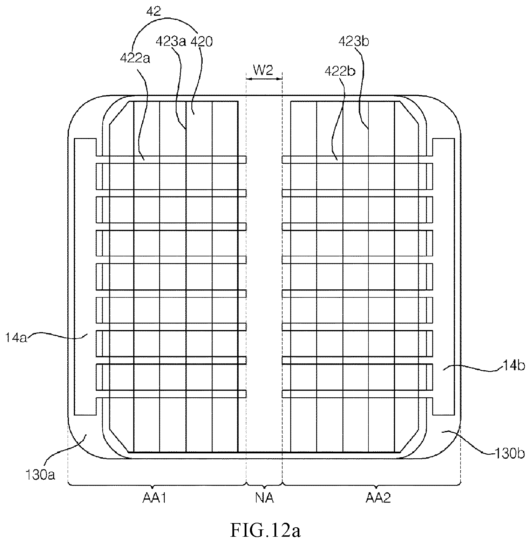

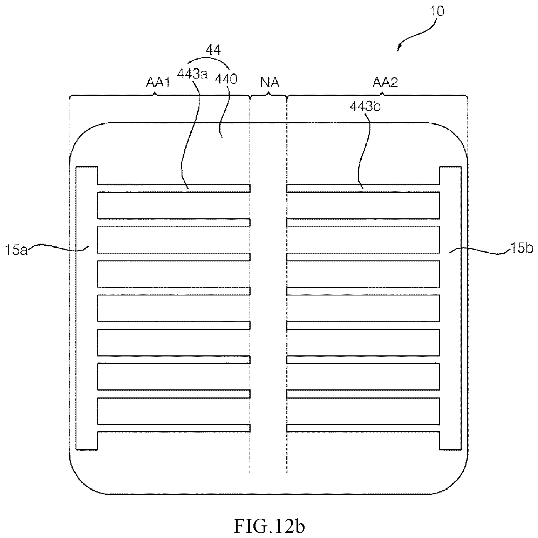

In addition, in the first electrode 42 and the second electrode 44, the second electrode layers 422 and 442 on the first electrode layer 440 may have shapes shown in FIG. 12a and FIG. 12b.

FIG. 12a is a plan view of a solar cell according to some other embodiments of the present disclosure, and FIG. 12b is a rear view of the solar cell according to some other embodiments of the present disclosure.

Referring to FIG. 12a, the first electrode 42 may be connected to the busbar electrodes 422a and 422b, and may form a plurality of finger electrodes 423a and 423b formed in an intersecting direction.

In this case, although widths of the busbar electrodes 422a and 422b may be greater than those of the finger electrodes 423a and 423b, the present disclosure is not limited thereto. Therefore, the widths of the busbar electrodes 422a and 422b may be equal to or less than those of the finger electrodes 423a and 423b.

Since the cutting region NA crosses the semiconductor substrate 122 in a direction intersecting the busbar electrodes 422a and 422b and is positioned in the first direction, the finger electrodes 423a and 423b may be arranged in parallel with the cutting region NA to cause the current to sufficiently flow.

As described above, in a case where the cutting region NA is arranged to be parallel to the finger electrodes 423a and 423b while the cutting region NA is arranged to cross the busbar electrodes 422a and 422b, magnitude of the current can be ensured while an area of the busbar electrodes 422a and 422b is reduced.

In this case, although boundary electrodes connected to the finger electrodes 423a and 423b and defining the solar cell regions AA1 and AA2 may be formed, the present disclosure is not limited thereto.

As described above, when the boundary electrodes are included, carriers may be efficiently collected in portions located at the edges of the solar cell regions AA1 and AA2. However, the present disclosure is not limited thereto, and the boundary electrodes are not required.

In addition, as shown in FIG. 12b, the second electrode layers 443a and 443b formed on the back surface of the solar cell 10 may include pad portions 15a and 15b formed in the terminal difference region SA and a plurality of busbar electrodes 443a and 443b protruding from the pad portions 15a and 15b towards the cutting region NA.

That is, a plurality of finger electrodes (not shown) having same shapes as the second electrode layers 442a and 442b of the first electrode 42 in FIG. 1 and spaced apart from each other at a predetermined interval may also be included. That is, although the finger electrodes are not shown in the figures, it is not excluded that finger electrodes may be formed.

As described above, in this embodiment, since the electrodes 42 and 44 of the solar cell 10 have a predetermined pattern, the solar cell 10 may have a bi-facial structure that allows light to be incident on the front surface and the back surface of the semiconductor substrate 122. Therefore, an increase in light used in the solar cell 10 can help to improve efficiency of the solar cell 10. However, the present disclosure is not limited thereto.

In the following, the solar cell module 100 provided by arranging the unit solar cells AA1 and AA2 in FIG. 11 in various manners (the unit solar cells are denoted by a reference sign 10' below) is described.

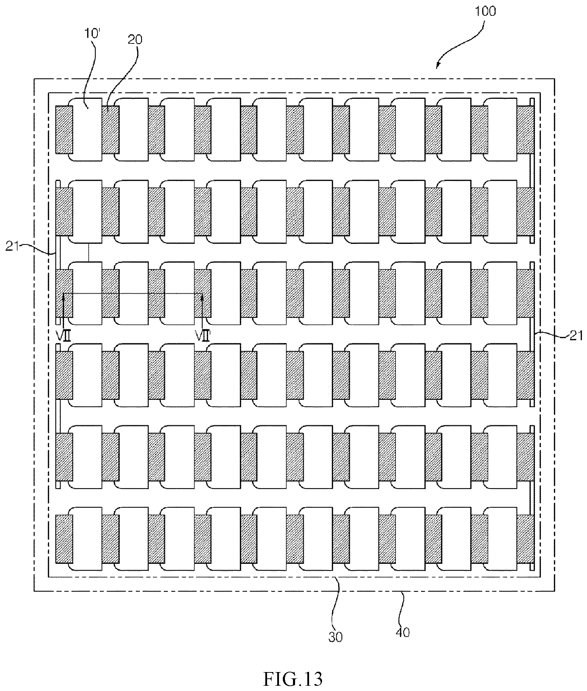

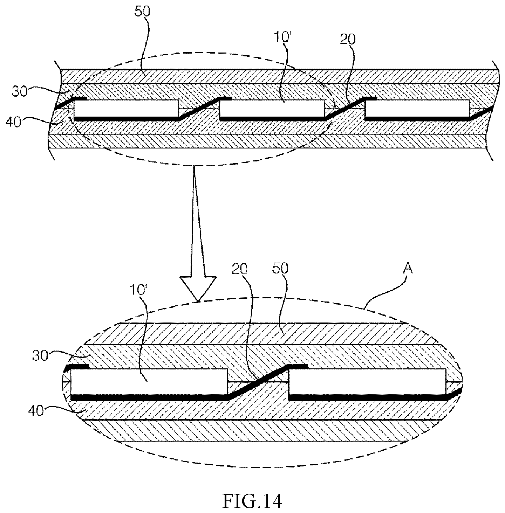

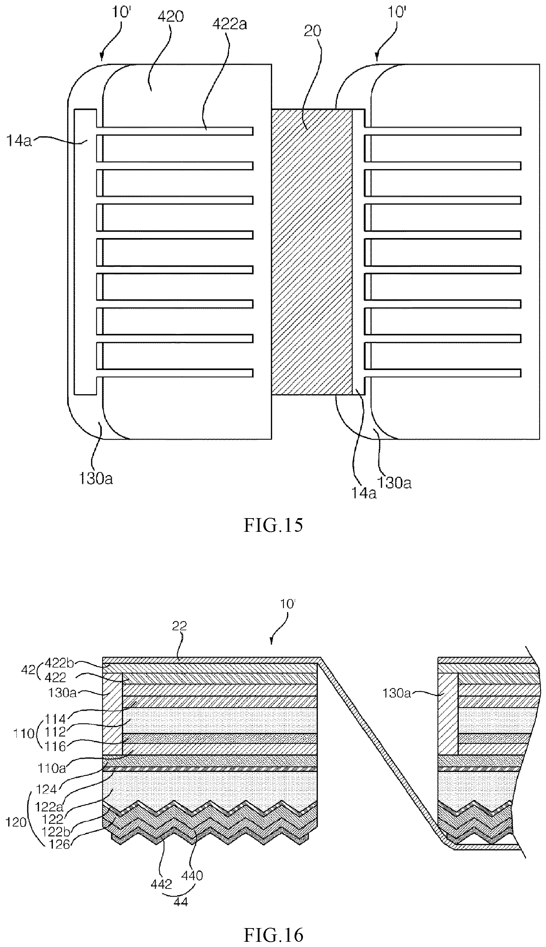

FIG. 13 is a plan view of a solar cell module according to some embodiments of the present disclosure, FIG. 14 is a sectional view of the solar cell module in FIG. 13 taken along VII-VII', FIG. 15 is a plan view of Part A in FIG. 14, and FIG. 16 is a sectional view of a solar cell module in the case of the unit solar cells as shown in FIG. 12a and FIG. 12b.

Referring to FIG. 13 to FIG. 15, in the solar cell module 100 according to some embodiments of the present disclosure, the plurality of tandem unit solar cells 10' are arranged in a matrix through connection pads 20 and are electrically connected to each other.

A plurality of the tandem unit solar cells 10' are connected in a row direction through the connection pads 20 and constitute a string, and a plurality of strings are connected to each other and constitute the solar cell module 100.

In consideration of bonding between the electrodes and the connection pads 20, charge collection efficiency, and the like, power generation efficiency of the solar cells can be optimized by using one of the connection pads 20 that connect adjacent tandem unit solar cells 10' to each other.

That is, one connection pad 20 meets an entirety of a second electrode 44 formed on a back surface of a first unit solar cell of two adjacent tandem unit solar cells 10', and further, meets a pad portion 14a of a first electrode 42 formed on a front surface of a second unit solar cell adjacent to the first unit solar cell. Similarly, another connection pad 20 meets an entirety of a second electrode 44 of the second unit solar cell, and meets a pad portion 14a of a first electrode 42 of a third unit solar cell adjacent to the second unit solar cell. In this case, the connection pad 20 is bonded to the pad portion 14a in such a manner as to overlap with more than 1/2 and less than 1% of the pad portion 14a, so that the connection pad 20 does not extend through the pad portion 14a and is detached from the terminal difference region SA. Therefore, the first photoelectric conversion portion 110 is not covered by the connection pad 20, thereby connecting the unit solar cells arranged in one string in series without reducing the area of the active region of the solar cell.

In addition, a bushing rod 21 connects the connection pad 20 connected to one end of a first-row string to the connection pad 20 connected to one end of a second-row string. Similarly, another bushing rod 21 connects a wiring connected to the other end of the second-row string to the connection pad 20 connected to the other end of a third-row string. In this regard, all the tandem unit solar cells 10' constituting the solar cell module 100 are connected in series with each other. The solar cell module 100 thus connected is sealed to be protected by a front package 30 and a back package 40, and laminated therewith in a state of being arranged between a front substrate 50 and a back substrate 60 to achieve integration.

The front substrate 50 is positioned as the front surface (a light-receiving surface where light enters) of the solar cell 10, and is made of a hard material without flexibility for impact protection. As an example, the front substrate 50 may be formed of tempered glass or the like that has high transmittance and an excellent damage prevention function.

The back substrate 60 is positioned as the back surface of the solar cell (a non-light-receiving surface where light does not enter), and is made of a flexible material different from the front substrate 50. The back substrate 60 prevents penetration of moisture from the back surface, thereby protecting the solar cell from an external environment. The back substrate 60 may have a multi-layer structure such as a layer for preventing penetration of moisture and oxygen and a layer for preventing chemical corrosion, and may be formed as a thin sheet made of an insulating material such as fluoropolymer (FP), polyester (PE), or fluoropolymer (FP).

The front package 30 is manufactured to have a thickness that enables the connection pad 20 to be completely buried, so that the rigid front substrate 50 is not physically impacted due to the connection pad 20.

The back package 40 is located between the back substrate 60 and the back surface of the unit solar cell 10' and is made of a transparent material that transmits light. The back package 40 also uses a resin product such as ethylene vinyl acetate (EVA) capable of absorbing shocks to prevent moisture penetration and protect the solar cell 10' from impact. In addition, the back package 40 is constituted to include a material that absorbs ultraviolet light to prevent deterioration, whereas the front package 30 does not include an ultraviolet light absorber to transmit all light, so that the development efficiency of the tandem unit solar cell 10' is good.

In addition, the solar cell module 100 may have a configuration shown in FIG. 16 in the case of the unit solar cells 10' shown in FIG. 12a and FIG. 12b.

In a solar cell module 100 according to some other embodiments of the present disclosure, a plurality of tandem unit solar cells 10' are arranged in a matrix through a plurality of wirings 22 and are electrically connected to each other.

A plurality of the tandem unit solar cells 10' are connected in a row direction through the plurality of wirings 22 and constitute a string, and a plurality of strings are connected to each other and constitute a solar cell module 100.

In consideration of bonding between the electrodes and the wirings 22, charge collection efficiency, and the like, power generation efficiency of the solar cells 10' can be optimized by using a plurality of the wirings 22 that connect adjacent tandem unit solar cells 10' to each other, and a number of the wires is the same as that of the busbar electrodes 422a and 422b.

That is, the wirings 22 are bonded across the pad portion 15a of the second electrode 44 and the busbar electrode 443a formed on a back surface of a first unit solar cell of two adjacent tandem unit solar cells 10', and are further bonded across the pad portion 14a of the first electrode 42 and the busbar electrode 422a formed on a front surface of a second unit solar cell adjacent to the first unit solar cell. In addition, wirings 21 are bonded across the pad portion 15a of the second electrode 44 and the busbar electrode 443a of the second unit solar cell, and are bonded across the pad portion 14a of the first electrode 42 and the busbar electrode 422a of a third unit solar cell adjacent to the second unit solar cell. Therefore, the unit solar cells arranged in one string are connected in series by a plurality of wirings 21.

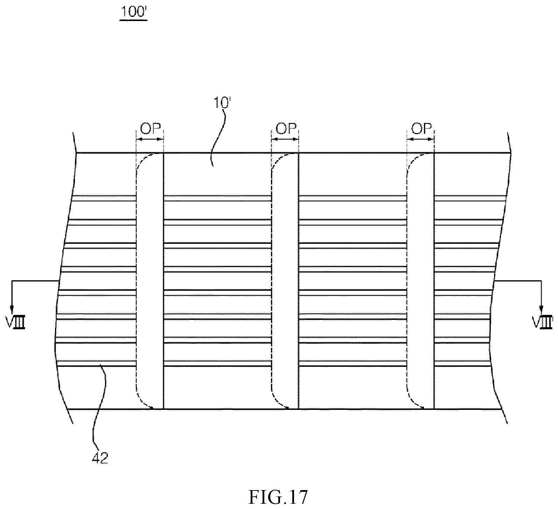

In addition, a tandem solar cell module formed by the unit solar cells 10' may have a shape the same as that in FIG. 17 to FIG. 19.

A tandem solar cell module 100 according to some other embodiments of the present disclosure will be described below with reference to FIG. 17 to FIG. 19.

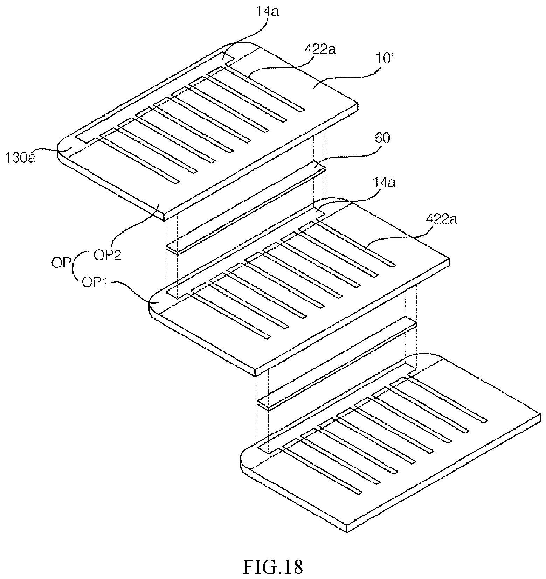

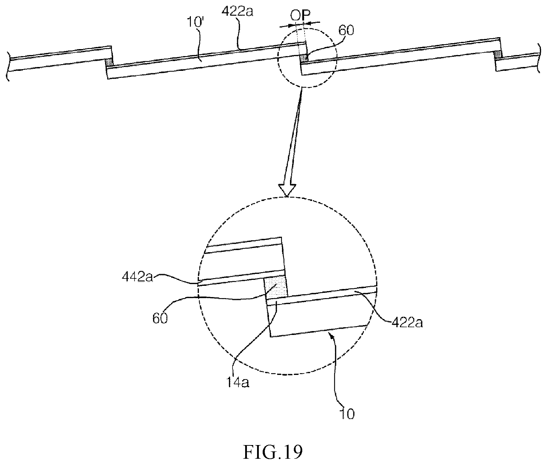

FIG. 17 is a plan view of a solar cell module according to some other embodiments of the present disclosure, FIG. 18 is an exploded perspective view of the solar cell module shown in FIG. 17, and FIG. 19 is a sectional view of the solar cell module shown in FIG. 17.

A tandem solar cell module 100' according to some other embodiments of the present disclosure is a solar cell module implemented by using the foregoing tandem unit solar cells 10', and the tandem solar cell module 100' is described in detail with reference to FIG. 17 to FIG. 19.

In the solar cell module 100' according to some other embodiments of the present disclosure, the plurality of tandem unit solar cells 10' described are stacked to overlap stepwise. For example, for a reference tandem unit solar cell 10', an adjacent upper tandem unit solar cell 10' and an adjacent lower tandem unit solar cell 10' partially overlap with the reference tandem unit solar cell 10', the upper tandem unit solar cell 10' is partially overlapped in an upper part of the reference tandem unit solar cell 10', and the lower tandem unit solar cell 10' is partially overlapped in a lower part of the reference tandem unit solar cell 10'.

In this specification, the upper tandem unit solar cell 10' and the lower tandem unit solar cell 10' may respectively refer to the tandem unit solar cell 10' arranged at a relatively lower part and the tandem unit solar cell 10' arranged at a relatively upper part based on any tandem unit solar cell 10' in the plurality of tandem unit solar cells 10' arranged to partially overlap stepwise as described above, and according to the tandem unit solar cell 10' as a reference, a same tandem unit solar cell 10' may be the upper tandem unit solar cell 10' or the lower tandem unit solar cell 10'.

The tandem unit solar cell 10' according to this embodiment includes an overlapping portion OP, and when a tandem solar cell module 100 to be described later is formed in the overlapping portion OP so that adjacent tandem solar cells 10 overlap, as a region of the tandem unit solar cell 10' corresponding to an overlapping section, each of the tandem unit solar cells 10' may include a first overlapping portion OP1 overlapping with the adjacent upper tandem unit solar cell 10' and a second overlapping portion OP1 overlapping with the adjacent lower tandem unit solar cell 10'.

For example, as long as the plurality of tandem unit solar cells 10' are stacked to overlap stepwise in an arrangement direction, a specific tandem unit solar cell 10' overlaps with the adjacent upper tandem solar cell 10' and the adjacent lower tandem solar cells 10' to include the first overlapping portion OP1 and the second overlapping portion OP2, and the first overlapping portion OP1 and the second overlapping portion OP2 are respectively arranged on two sides of the tandem solar cell 10 to be opposite to each other in the arrangement direction.

The overlapping portion OP2 according to this embodiment may be rectangular or geometrically variable according to the shape of the tandem unit solar cell 10'. However, the shape of the overlapping portion OP is not limited to the description or the drawings, and should include a range that can be easily designed and changed to the shape of the overlapping portion by those of ordinary skill.

In this embodiment, a width of the overlapping portion is kept within the width of the side insulating layer, so that stable modularization can be performed and a large light-receiving area can be ensured during the formation of the tandem solar cell module 100, thereby producing excellent solar cell output. When the width of the overlapping portion OP is less than 1 mm, bonding stability of adjacent tandem unit solar cells 10' may be reduced during the modularization. When the width of the overlapping portion OP is more than 3 mm, the light-receiving area of the tandem unit solar cell 10' is excessively reduced, and the output of the solar cell can be reduced instead.

Widths of the first overlapping portion OP1 and the second overlapping portion OP2 may be the same as or different from each other, and when the widths are different from each other, within a range of about 1 mm to about 3 mm, the widths of the first overlapping portion OP1 and the second overlapping portion OP2 may also be different.

That is, as shown in FIG. 17, in the tandem solar cell module 100' according to some other embodiments of the present disclosure, when a plurality of tandem unit solar cells 10' are stacked to overlap stepwise, lower electrodes of the adjacent upper tandem solar cells 10 are electrically connected to upper electrodes of the lower tandem solar cells 10 through conductive adhesive portions 14a and electrode portions 14b, which is conducive to productivity and manufacturing costs, can reduce a process defect rate, and maximizes efficiency of the solar cell by minimizing optical losses.

For example, the first overlapping portion OP1 of the reference tandem unit solar cell 10' and the second overlapping portion OP2 of the upper tandem unit solar cell 10' overlap with each other, and the second overlapping portion OP2 of the reference tandem unit solar cell 10' and the first overlapping portions OP1 of the lower tandem unit solar cell 10' overlap with each other, so as to be stacked stepwise.

Further, in some other embodiments of the present disclosure, the pad 14a is formed at the first overlapping portion OP1 overlapping during the modularization, thereby contributing to the solar cell output. That is, since the first overlapping portion OP also overlaps with the upper tandem unit solar cell 10' and not exposed as a light-receiving surface during the modularization, there may be no reduction in the output of the solar cell formed according to the pad. Instead, the light-receiving area can be maximized within a predetermined area of the solar cell module.

In the tandem solar cell module 100' according to some other embodiments of the present disclosure, the connecting portion is arranged between the second overlapping portion OP2 of the adjacent upper tandem solar cell 10 and the first overlapping portion OP1 of the lower tandem solar cell 10, so that the adjacent tandem unit solar cells 10' can be electrically and physically bonded.

For example, referring to FIG. 18 and FIG. 19, the connection portion may include a conductive adhesive portion 60 and a pad portion 14a, and based on two adjacent tandem unit solar cells 10', the conductive adhesive portion 60 may be integrally arranged between the second overlapping portion OP2 of the upper tandem unit solar cell 10' and the first overlapping portion OP1 of the lower tandem unit solar cell 10'. In this specification, "integrally arranged" includes a case where the conductive adhesive portion is physically perfectly arranged in the region or space and also a case where there is inevitably a part excluding a part. The conductive adhesive portion 60 includes a polymer blend of epoxy acrylic fluorine, silicon, polyamide, and the like and has adhesive properties, and thus has conductive properties while physically stably binding adjacent tandem unit solar cells 10', thereby having a function of electrically connecting the adjacent tandem unit solar cells 10'. The conductive adhesive part 60 may be made of various materials, which may be made of an electrical conductive adhesive (ECA) or the like as an example. However, the type of the conductive adhesive portion 60 is not limited to the described content, and as long as the adjacent tandem unit solar cells 10' can be physically and electrically connected, a range that can be easily selected by those of ordinary skill may be included.

In this case, the pad portion 14a serves as the pad 14a connected to the first electrode 42, which may be integrally arranged on one side of the first overlapping portion OP1 as the terminal difference region SA.

As described above, the second electrode layer 442b of the second electrode 44 formed at the second overlapping portion OP2 of the upper tandem unit solar cell 10' and the pad portion 14a formed at the first overlapping portion OP1 of the lower tandem unit solar cell 10' are in electrical contact through the conductive adhesive portion 60, thereby constituting an electrical connection between two adjacent unit solar cells 10'.

That is, the conductive adhesive portion 60 electrically connected to the second electrode 44 of the upper tandem unit solar cell 10' meets the pad portion 14a electrically connected to the first electrode 42 of the lower tandem unit solar cell 10, so the upper tandem unit solar cell 10' and the lower tandem unit solar cell 10' can be electrically and physically connected.

Therefore, in the tandem solar cell module 100' according to some other embodiments of the present disclosure, a plurality of tandem unit solar cells 10' are stacked by using the connection portions described above to be formed to overlap stepwise, thereby improving productivity and reducing a defect rate.

The features, structures, effects, and the like above are included in at least one embodiment of the present disclosure, and are not necessarily limited to only one embodiment. In addition, the features, structures, effects, and the like exemplified in various embodiments can also be implemented by combining or modifying other embodiments by those skilled in the art to which the embodiments belong. Therefore, content related to such combinations and modifications should be construed as being included in the scope of the present disclosure.

## Claims

1. A solar cell, comprising:
a first photoelectric conversion portion, comprising a photoelectric conversion layer, a first transport layer on one side of the photoelectric conversion layer, and a second transport layer on the other side of the photoelectric conversion layer, wherein the photoelectric conversion layer comprises a perovskite compound;
a second photoelectric conversion portion, arranged below the second transport layer of the first photoelectric conversion portion and having a different material or structure from the first photoelectric conversion portion;
a side insulating layer, formed on at least one side surface of the first photoelectric conversion portion;
a first electrode, electrically connected to the first photoelectric conversion portion on one surface of the first photoelectric conversion portion serving as a light-receiving surface; and
a second electrode, electrically connected to the second photoelectric conversion portion and arranged below the second photoelectric conversion portion.

2. The solar cell according to claim 1, wherein the first photoelectric conversion portion has a smaller area than the second photoelectric conversion portion to have a terminal difference region on the second photoelectric conversion portion, and
the terminal difference region is formed on two side surfaces of the first photoelectric conversion portion that are opposite to each other.

3. The solar cell according to claim 2, wherein the side insulating layer is formed in the terminal difference region.

4. The solar cell according to claim 3, wherein a cutting region positioned across the first photoelectric conversion portion is not formed in the light-receiving surface .

5. The solar cell according to claim 4, wherein the cutting region has a shape extending in a first direction in a central region of the solar cell, and
the side insulating layer has a shape extending in the first direction in the terminal difference region.

6. The solar cell according to claim 5, further comprising: unit solar cell regions arranged between the cutting region and the side insulating layer,
wherein the unit solar cell regions are spaced apart from each other through the cutting region.

7. The solar cell according to claim 6, wherein the first electrode comprises first unit electrodes formed in each of the unit solar cell regions, and
each of the first unit electrodes comprises a pad portion formed on the side insulating layer, and busbar electrodes connected to the pad portion and spaced apart from each other and extending in a second direction perpendicular to the first direction.

8. The solar cell according to claim 6, wherein the second electrode comprises second unit electrodes formed in each of the unit solar cell regions, and
each of the second unit electrodes corresponds to all of the busbar electrodes formed from the pad portion of the first unit electrode.

9. A solar cell, comprising:
a first photoelectric conversion portion, comprising a first long side and a second long side formed along a major axis and parallel to each other, and a first short side and a second short side formed along a minor axis intersecting the major axis and parallel to each other, and comprising a photoelectric conversion layer, a first transport layer on one side of the photoelectric conversion layer, and a second transport layer on the other side of the photoelectric conversion layer, wherein the photoelectric conversion layer comprises a perovskite compound;
a second photoelectric conversion portion, arranged below the second transport layer of the first photoelectric conversion portion and having a different material or structure from the first photoelectric conversion portion;
a side insulating layer, formed to abut against the first long side of the first photoelectric conversion portion;
a first electrode, electrically connected to the first photoelectric conversion portion on one surface of the first photoelectric conversion portion serving as a light-receiving surface; and
a second electrode, electrically connected to the second photoelectric conversion portion and arranged below the second photoelectric conversion portion,
wherein the first electrode comprises a pad portion formed on the side insulating layer, and busbar electrodes extending from the pad portion, spaced apart from each other, and protruding along the minor axis.

10. A solar cell module, comprising:
solar cells; and
connecting components, connected between adjacent solar cells,
wherein each of the solar cells comprises:
a first photoelectric conversion portion, comprising a first long side and a second long side formed along a major axis and parallel to each other and a first short side and a second short side formed along a minor axis intersecting the major axis and parallel to each other, and comprising a photoelectric conversion layer, a first transport layer on one side of the photoelectric conversion layer, and a second transport layer on the other side of the photoelectric conversion layer, wherein the photoelectric conversion layer comprises a perovskite compound;
a second photoelectric conversion portion, arranged below the second transport layer of the first photoelectric conversion portion and having a different material or structure from the first photoelectric conversion portion;
a side insulating layer, formed to abut against the first long side of the first photoelectric conversion portion;
a first electrode, electrically connected to the first photoelectric conversion portion on one surface of the first photoelectric conversion portion serving as a light-receiving surface; and
a second electrode, electrically connected to the second photoelectric conversion portion and arranged below the second photoelectric conversion portion,
wherein the first electrode comprises a pad portion formed on the side insulating layer, and busbar electrodes extending from the pad portion, spaced apart from each other, and protruding along the minor axis.

11. The solar cell module according to claim 10, wherein the second electrode of one of the solar cells and the pad portion of another solar cell adjacent to the one of the solar cells are electrically connected by overlapping adjacent solar cells.

12. The solar cell module according to claim 11, wherein each of the solar cells comprises a first overlapping portion overlapping with an adjacent upper solar cell, and a second overlapping portion overlapping with an adjacent lower solar cell, and
each of the connecting components comprises a conductive adhesive portion integrally arranged between the second overlapping portion of the upper solar cell and the first overlapping portion of the lower solar cell.

13. The solar cell module according to claim 12, wherein the pad portion and the conductive adhesive portion contact with each other and are electrically connected.

14. The solar cell module according to claim 10, wherein the solar cells are arranged apart from one another, and each of the connecting components connects the first electrode of one solar cell and the second electrode of another solar cell adjacent to the one solar cell.

15. The solar cell module according to claim 14, wherein the connecting component contacts with the pad portion of the first electrode of one of the solar cells, entirely covers the second electrode of the adjacent solar cell, and is electrically connected to the solar cells.

16. A method for manufacturing a solar cell, comprising:
forming a second photoelectric conversion portion comprising a conductive region on a semiconductor substrate;
forming side insulating layers on side surfaces opposite to each other on the second photoelectric conversion portion;
forming, between side insulating layers, a first photoelectric conversion portion, wherein the first photoelectric conversion portion comprises a photoelectric conversion layer, a first transport layer on one side of the photoelectric conversion layer, and a second transport layer on the other side of the photoelectric conversion layer, and the photoelectric conversion layer comprises a perovskite compound;
forming, on one surface of the first photoelectric conversion portion serving as a light-receiving surface, a first electrode electrically connected to the first photoelectric conversion portion and having a cutting region to open a center, and a second electrode electrically connected to the second photoelectric conversion portion and arranged below the second photoelectric conversion portion and having the cutting region; and
forming unit solar cells by cutting along the cutting region where the first electrode and the second electrode are not formed.

17. The method according to claim 16, wherein the forming side insulating layers comprises:
arranging a mask exposing the side surfaces on the second photoelectric conversion portion; and
depositing the side insulating layer to a predetermined height on the exposed side surface.

18. The method according to claim 17, wherein, during forming the first electrode, the first electrode is formed to comprise a pad portion formed on the side insulating layer, and busbar electrodes extending from the pad portion, spaced apart from each other, and protruding towards the cutting region.

19. The method according to claim 17, wherein the forming unit solar cells comprises:
performing primary cutting on the solar cell to a predetermined depth from a back surface of the second photoelectric conversion portion by laser scribing; and
performing mechanical machining based on the cutting region to perform secondary cutting to separate the solar cell into the unit solar cells.

20. The method according to claim 19, wherein the predetermined depth in the primary cutting is a depth that does not reach the first photoelectric conversion portion.
